# EUROPEAN PATENT APPLICATION

(11) **EP 1 621 930 A2**
(43) Date of publication of application: **01.02.2006**
(21) Application number: 05014065.6
(22) Date of filing: 29.06.2005
(51) Int. Cl.: G03F 7/20

(54) **Illumination system for a microlithographic projection exposure apparatus**

(30) Priority: 29.07.2004 US 591985 P; 29.11.2004 US 631564 P
(71) Applicant: Carl Zeiss SMT AG, 73447 Oberkochen (DE)
(72) Inventor: Fiolka, Damian, 73447 Oberkochen (DE); Lindner, Ralf, 73447 Oberkochen (DE); Scharnweber, Ralf, 73430 Aalen (DE)
(74) Representative: Schwanhäusser, Gernot

(57) **Abstract**

An illumination system for a microlithographic projection exposure apparatus (PEA) has a first polarization manipulator (PM1; PM21; PM31; PM41; PM51; PM611, PM621; PM111), a second polarization manipulator (PM2; PM22; PM32; PM42; PM52; PM612, PM622; PM112) and at least one optical element (L1, L2, 18, 30) located in between. The polarization manipulators ensure that the direction of the electric field vector of a light ray (R) varies in time between the polarization manipulators, whereas the polarization state is fixed outside the polarization manipulators. This prevents high energy light from inducing birefringence in optical elements arranged between the two polarization manipulators.

## Description

### BACKGROUND OF THE INVENTION

### 1. Field of the invention

The invention relates generally to illumination systems for microlithographic projection exposure apparatus. More particularly, the invention relates to illumination systems that allow to illuminate a mask with projection light having a predetermined polarization state.

### 2. Description of Related Art

Microlithography (also called photolithography) is a technology for the fabrication of integrated circuits, liquid crystal displays and other microstructured devices. More particularly, the process of microlithography, in conjunction with the process of etching, is used to pattern features in thin film stacks that have been formed on a substrate, for example a silicon wafer. At each layer of the fabrication, the wafer is first coated with a photoresist which is a material that is sensitive to radiation, such as deep ultraviolet (DUV) light. Next, the wafer with the photoresist on top is exposed to projection light through a mask in a projection exposure apparatus, such as a step-and-scan tool. The mask contains a circuit pattern to be projected onto the photoresist. After exposure the photoresist is developed to produce an image corresponding to the circuit pattern contained in the mask. Then an etch process transfers the circuit pattern into the thin film stacks on the wafer. Finally, the photoresist is removed.

A projection exposure apparatus typically includes an illumination system, a projection lens and a wafer alignment stage for aligning the wafer coated with the photoresist. The illumination system illuminates a region of the mask with an illumination field that may have the shape of an elongated rectangular slit. As the technology for manufacturing microstructured devices advances, there are ever increasing demands also on the illumination system. For example, it has been found out that illuminating the mask with projection light having a carefully selected polarization state may considerably improve the imaging of the mask onto the photoresist. At present, illuminating the mask with linearly polarized light seems to be particularly advantageous.

However, the illumination of the mask with linearly polarized light may also involve various difficulties. One of the most prominent problems is an effect which is usually referred to as polarization-induced birefringence. This effect, which is, for example, described in papers by N. F. Borelli et al. entitled "Excimer laser-induced expansion in hydrogen-loaded silica", Appl. Phys. Lett., Vol. 78, No. 17, April 23, 2001, pages 2452 to 2454, and "Polarized excimer laser-induced birefringence in silica", Appl. Phys. Lett., Vol. 80, No. 2, January 14, 2002, pages 219 to 221. The effect relates to the emergence of birefringence in almost all suitable optical materials when they are exposed for a longer time to linearly polarized light having a high intensity and a constant polarization direction. This birefringence is caused by small density variations within the material. In birefringent materials, the refractive index varies as a function of the orientation of the material with respect to the direction of incident light and also of its polarization. In the case of polarization induced birefringence, either the slow or the fast axis is parallel to the direction in which the electric field vector of the incident light oscillates.

As long as this direction does never vary, polarization-induced birefringence is of little concern because the electric field vector still oscillates parallel to either the fast or the slow axis of the material. Therefore the typical effects caused by birefringence, for example, conversion of linearly polarized light into elliptically polarized light, do not occur.

Often, however, it is desired that masks can be illuminated with linearly polarized light having different - and not necessarily orthogonal - polarization directions. For example, it has been proposed to place a polarization manipulator in a pupil plane that produces a tangential polarization distribution across the area of the manipulator. Then all possible polarization directions occur in subsequent optical elements. If one changes the illumination setting by inserting such a polarization manipulator, the direction of the electric field vectors do not necessarily have to be parallel to the slow or fast axis of the birefringence induced by the former illumination setting. Thus the polarization-induced birefringence will now become noticeable, i.e. the polarization state of light in the new illumination setting will be disturbed by birefringence.

From US 5 442 184 A an illumination system is known which allows to vary the polarization direction of linearly polarized light that illuminates the mask.

A similar concept is employed in an illumination system known from US 5 233 460. In this known illumination system, however, subsequent laser pulses have orthogonal polarization states so that the mask is exposed to quasi-depolarized light.

From US 6 483 573 B1 another illumination system for a microlithographic projection apparatus is known in which a half-wave plate is rotated with a high angular velocity around the optical axis. The angular velocity is synchronized with the frequency of the laser pulses such that the linear polarization state of subsequent pulses alternates between two orthogonal directions. As a result, the photoresist on the wafer is exposed to quasi-depolarized light.

### SUMMARY OF THE INVENTION

It is an object of the present invention to provide an illumination system in which the aforementioned adverse effects of polarization-induced birefringence is reduced or even eliminated.

According to a first aspect of the invention, this object is achieved by an illumination system for a microlithographic projection exposure apparatus that comprises a first and a second polarization manipulator and at least one optical element arranged in between. The electric field vector of a light ray entering the first polarization manipulator oscillates in a first direction that is fixed in time. The electric field vector of a light ray emitted from the first polarization manipulator oscillates in a second direction that varies in time. The electric field vector of a light ray emitted from the second polarization manipulator oscillates in a third direction that is fixed in time.

Such an illumination system ensures that all optical elements located between the first and the second polarization manipulator are exposed to light whose polarization direction varies in time relative to the optical element.

As a result, density variations that are responsible for polarization-induced birefringence do not occur, or if such variations occur, they are symmetrical so that the net birefringence is zero. Symmetrical here means that the fast axis of polarization-induced birefringence, which would be caused (if taken alone) by first density variations, coincides with the slow axis of another polarization-induced birefringence, which would be caused by second density variations. ,

The second polarization manipulator has the task of ensuring that the varying directions, in which the electric field vector oscillates between the two polarization manipulators, are changed such that the direction is fixed in time again.

The variation of the second direction, i.e. the direction, in which the electric field vector oscillates between the two polarization manipulators, may be achieved using different approaches.

The perhaps most simple approach is to ensure that the light between the two polarization manipulators is elliptically or, more preferably, circularly polarized. In this case the time variations of the second direction are extremely fast. The closer the ellipticity of the elliptically polarized light is to one (this corresponds to circularly polarized light), the less birefringence is induced by the light in the at least one optical element.

For transforming the linear polarization state of the incident light into an elliptical or circular polarization state, any known devices may be used that have this property. Frequently, a quarter-wave plate or a three-quarter-wave plate is used to this end. If the polarization state between the two polarization manipulators shall be circular, the quarter-wave plate or the three-quarter-wave plate should have a principal axis that forms an angle of 45° to the first direction (i.e. polarization direction of incoming light). Alternatively, a combination of an appropriately oriented linear polarizer with a half-wave plate can also been used as a circular polarizer.

The second polarization manipulator has the task of transforming elliptically or circularly polarized light into linearly polarized light again. To this end, the second polarization manipulator may, for example, also be a quarter-wave-plate, a three-quarter-wave plate or a combination of an appropriately oriented linear polarizer with a half-wave plate, as is known in the art as such.

Another way of varying the second direction in time is to use polarization manipulators wherein each manipulator comprises a polarization rotator. In this context a polarization rotator shall denote any device that is capable of rotating a first fixed polarization direction to another fixed polarization direction. This rotation is, compared to the rotation of the electric field vector of elliptically or circularly polarized light, very slow. For preventing polarization-induced birefringence, however, the angular velocity of the rotation does not matter.

Also in the case of slow rotations of the polarization direction, there are many devices known in the art that may be used as a polarization rotator.

For example, a half-wave plate has the property of rotating the polarization direction by an angle 2β, wherein β is the angle between a principal axis of the half-wave plate and the polarization direction of incident light. If this angle β equals 45°, the polarization state of incident light is transformed into an orthogonal polarization state. A rotator that rotates the polarization direction by 90° independent of the input polarization direction may comprise a first half-wave plate and a second half-wave plate that are arranged such that a principal axis of the first half-wave plate forms an angle of 45° with a principal axis of the second half-wave plate.

Another approach to rotate a polarization state is to use a polarization rotator comprising an optically active material. These materials have the property of rotating the polarization direction dependent on the distance the light ray propagates within the respective material. By using active materials of different thicknesses, it is possible to vary the angle of rotation.

Particularly advantageous is the use of a liquid crystal as an active material. Certain liquid crystals allow to rotate the polarization direction depending on the strength of an electric field to which the crystal is exposed. Thus it is possible to rotate the polarization direction between the two polarization manipulators continuously and merely by changing the voltage applied to the liquid crystal of the first polarization manipulator.

Alternatively, at least one polarization rotator may comprise a polarization modulator that may, for example, exploit the magneto-optic or the electro-optic effect. Such modulators are available as Faraday, Kerr or Pockels rotators, for example.

The polarization direction of the light between the two polarization manipulators may be continuously or intermittently rotated. If the polarization direction is rotated intermittently, it should be ensured that the angles of rotation are determined in such a way that in the end symmetric density variations are caused within the optical elements between the polarization manipulators so that no polarization-induced birefringence can occur. In the simplest case, this angle is 90° or an uneven multiple thereof.

For achieving an intermittent rotation of the polarization direction, the first and the second polarization manipulators may each comprise an actuator for displacing a polarization rotator between a first position, in which the ray passes through the polarization rotator, and a second position in which the ray does not pass through the polarization rotator. In this case there is no need to rotate the rotator itself or to apply varying control voltages.

If the angle of rotation is 90° or an uneven multiple thereof, it is possible to arrange between the first and the second polarization manipulator a third polarization manipulator that transforms a linear homogeneous polarization distribution into a linear radial or linear tangential polarization distribution. Such an additional polarization manipulator is usually arranged in or in close proximity of a pupil plane of the illumination system. If there were other angles of rotation, such a third polarization manipulator would not function because it requires a certain input polarization state or a polarization state orthogonal thereto in order to generate a linear radial or linear tangential polarization distribution.

The third polarization manipulator may comprise an optically active crystal having an optic axis that is parallel to an optical axis of the illumination system. The crystal has a thickness along a direction of the optic axis that is locally varying. Such a third polarization manipulator, which as such is disclosed in US Ser. No. 60/537327, allows to obtain any arbitrary polarization distribution if the polarization distribution of the incident light bundle is known and constant in time and if the light passes the crystal at least approximately parallel to its optic axis.

According to another advantageous embodiment, a third polarization manipulator is provided that produces a polarization distribution having a four-fold symmetry with polarization directions alternating between radial and to tangential orientations. The first polarization manipulator is configured to rotate the first direction by m·90°, m = 1, 3, 5, ..., and the second polarization manipulator has the function of a half-wave plate having an optic axis whose direction can be varied by an angle of n·45°, n = 1, 3, 5, .... Such a third polarization manipulator has the advantage that a single half-wave plate (or any equivalent device) suffices to obtain a radial or tangential polarization distribution irrespective of the rotation introduced by the first polarization manipulator. Thus it is not necessary to use a bulky rotator as the second polarization manipulator. This is an important advantage since the second polarization manipulator is usually located immediately in front of the mask plane. In this part of the illumination system, the available space for housing additional optical elements is often very restricted.

Depending on the design of the third polarization manipulator, the polarization directions produced by the third polarization manipulator may discretely or continuously change from radially to tangentially. The above mentioned optically active crystal having a locally varying thickness distribution is particularly suited for obtaining a polarization distribution having a four-fold symmetry.

Another way to enable the use of an additional polarization manipulator is to have at least two pairs of polarization manipulators arranged in front of and behind the additional polarization manipulator. Then it is ensured that light passing through the additional polarization manipulator has always the same linear polarization state. This generally applies to all polarization manipulators that require a certain input polarization state.

In order to make sure that as many optical elements as possible are protected from polarization-induced birefringence, the first and the second polarization manipulators should be arranged at the very beginning and the very end of the illumination system, respectively. Then all optical elements arranged in between are exposed to light whose direction, in which the electric field vector oscillates, varies in time and therefore reduces or eliminates the risk of disturbances caused by polarization-induced birefringence.

According to a second aspect of the invention, the above stated object is achieved by an illumination system that comprises an optical element on which, during operation of the illumination system, a linearly polarized light ray having a fixed polarization direction is incident. The illumination system further comprises an actuator for rotating the optical element around an axis of rotation. A control unit for the actuator is provided that controls the actuator according to a predetermined control pattern.

Thus, according to this second aspect of the invention, it is not the polarization direction that is varied with respect to a fixed optical element, but, in reverse, the angular position of the optical element is varied with respect to a fixed polarization direction of incident light. In both cases the result is essentially the same, namely the relative position between the polarization direction of incident light and the orientation of the optical material traversed by the light is changed. Therefore density variations that are responsible for polarization-induced birefringence do not occur, or if such variations occur, they are symmetrical so that the net birefringence is zero.

Rotating the optical element can also be useful in cases in which the polarization direction of incident light is not completely fixed or the incident light is not completely linearly polarized at all. For example, if there is some kind of jitter of the polarization direction of the incident light, or if the incident light is elliptically polarized and the ellipticity is large, polarization-induced birefringence may still occur. Rotating the optical element then also allows to substantially reduce the polarization-induced birefringence.

Usually, however, the polarization direction will be substantially fixed. In this case it is advantageous if the actuator is adapted for rotating the optical element by 90° or an uneven multiple thereof. Even if density variations in the material of the optical element cannot be prevented, it is ensured that such density variations are, if any, symmetrical so that there is no net effect of birefringence.

In certain cases it may be necessary that the control unit initiates the rotation during pauses between exposure operation intervals of the illumination system. This means that rotations are only allowed if the photoresist is not exposed to projection light. For example, if the optical element does not have an axis of rotational symmetry, rotating the optical element would change its optical properties. Usually this cannot be tolerated during an exposure process. In such a case it is not only necessary to rotate the optical element during pauses between exposure operation intervals, but also to illuminate the element with compensation light generated by the projection light source or an additional light source. This will be more fully explained further below.

However, optical elements in illumination systems are usually rotationally symmetric. Thus the control unit may initiate the rotation during exposure operation of the illumination system without altering its optical properties. Furthermore, it is possible to continuously rotate the optical element so that density variations in the material are completely or at least substantially prevented.

Instead of continuously rotating the optical element during operation, it is also possible to rotate the optical element only during pauses between exposure operation intervals, preferably by an angle of rotation of 90° or an uneven multiple thereof, and then to resume operation with the optical element rotated by the desired angle. During the next pause, the optical element is rotated again, for example by reversing it back to its original position. Following this procedure it is ensured that the optical element is, for substantially equal durations, exposed to light having two different (preferably orthogonal) polarization directions. This procedure can also be carried out if the optical element has an axis of manifold symmetry, e.g. three- or fourfold symmetry. The symmetry then determines the rotational angle of the optical element

Usually an illumination system comprises a plurality of optical elements that are traversed by the projection light. In many cases it may be sufficient to rotate only those optical elements in which very high radiation densities occur. These are usually lenses with small diameters or located in the proximity of pupil planes. If there are more than one optical element that shall be rotated, and particularly in those cases in which such optical elements are adjacent to one another, it may be advantageous if the actuator is connected to a plurality of optical elements. This allows to rotate the plurality of optical elements simultaneously with only one single actuator.

It should be noted that the above mentioned considerations relating to the second aspect of the invention also apply in those cases in which linearly polarized light rays with different polarization directions are impinging on a particular point on an optical element having. If there is no dominant polarization direction, no polarization-induced birefringence will occur. However, if there is a dominant direction, rotation of the at least one optical element will again reduce the occurrence of polarization-induced birefringence.

According to a third aspect of the invention, the above stated object is achieved by a projection exposure apparatus for exposing a layer that is sensitive to light having a predetermined wavelength, comprising:
a) a first light source emitting projection light rays having the predetermined wavelength,
b) an optical element containing at least one point that is penetrated by projection light rays such that projection light at the at least one part has a dominant overall first polarization direction,
c) a second light source emitting compensation light rays that can be directed to the optical element such that compensation light at the at least one point has a dominant overall second polarization direction that forms an angle with the dominant overall first polarization direction between 45,1° and 90°.

This aspect of the invention is based on the consideration that neither the polarization direction of the projection light nor the angular position of the optical elements have to be changed if compensation light is used for offsetting polarization-induced density variations that occur during normal operation of the system and may eventually cause birefringence. The dominant overall second polarization direction of the compensation light at the at least one point of the optical element has to form an angle with the dominant overall first polarization direction exceeding 45°, because otherwise the polarization-induced density variations cannot be - at least partly - compensated for, but would even be increased. Ideally, the angle between the two directions amounts to 90°.

If the compensation light has a wavelength for which the layer is not sensitive, the second light source emitting the compensation light can be operated while the layer is exposed by the projection light. This has the advantage that the compensation process is, on the time scale, not limited to intervals between subsequent exposures, maintenance intervals or other interruptions of the operation. It has only to be made sure that in this case the wavelength of the compensation light is selected such that it causes not significantly less polarization-induced density variations than the projection light. If the wavelength is selected such that the response of the material is much stronger to the compensation light, it may be sufficient to direct the compensation light only during short time intervals to the optical element.

An identical response of the material of the optical element to linearly polarized light or, more generally light having a dominant overall second polarization direction, is achieved if both the projection light and the compensation light have the same wavelength. However, in this case it has to be ensured by a control unit connected to the second light source that the second light source emits compensation light only during time intervals in which the light sensitive layer cannot be exposed by the compensation light rays. The control unit may, for example, communicate a start command to the second light source only at the beginning of time intervals during which no wafer with a light sensitive layer on top is located in front of the projection lens.

In an advantageous embodiment the projection exposure apparatus comprises a shutter that is connected to the control unit and prevents an exposure of the light sensitive layer by the compensation light. This allows to direct compensation light on the optical element even during the short intervals between subsequent exposures. If all optical elements between the first light source and the light sensitive layer shall profit from the birefringence compensation induced by the compensation light, such a shutter should be arranged immediately in front of the light sensitive layer. If the shutter is arranged between an illumination system and a projection lens of the projection exposure apparatus, only the elements within the illumination system can be protected from adverse effects caused by polarization induced birefringence. Often this is sufficient because the light intensities in the projection lens are, due to absorption in preceding optical elements, smaller than in the illumination system. These light intensities may be too small to cause density variations in the optical elements of the projection lens.

If the wavelength of the projection light and the compensation light shall be identical, it could be envisaged to provide two different light sources that emit light with different polarization directions. However, the same effect can be achieved with only one light source and an additional polarization manipulator that produces from the incident light either projection light or compensation light depending on whether the polarization manipulator is inserted into a path of light rays or not. With the help of beam splitters and combiners it is also possible to produce simultaneously projection and compensation light having different polarization directions. A polarizing filter at the exit side pf the illumination system can then remove all undesired polarization directions from the light.

If the incident light is linearly polarized, the polarization manipulator may rotate the polarization directions of light passing it by an angle of more than 45° and preferably by an angle of 90° or an uneven multiple thereof. This results, in the case of incident linearly polarized light, in compensation light rays that are also linearly polarized, but have a different (preferably orthogonal) polarization direction. In this respect it does not matter whether the projection light is produced with the polarization manipulator inserted into the path of rays or removed from it.

In order to achieve a full compensation of polarization-induced density variations, the angle formed between the dominant overall first and second polarization directions should be substantially 90°. If there are projection light rays traversing the at least one point of the optical element that have different polarization directions things may be arranged, for example by an appropriate second source or a polarization manipulator, such that the compensation light rays penetrating the at least one point have polarization directions that are at least substantially orthogonal to the polarization directions of the respective projection light rays penetrating the at least one point.

### BRIEF DESCRIPTION OF THE DRAWINGS

Preferred embodiments of the invention are described in detail below with reference to the drawings in which
- FIG. 1: shows a perspective and simplified view of a projection exposure apparatus comprising an illumination system;
- FIG. 2: shows a simplified meridional section through the illumination system of FIG. 1 including a quarter-wave plate and a three-quarter-wave plate as polarization manipulators;
- FIG. 3: shows the illumination system of FIG. 2 in a still further simplified illustration;
- FIG. 4a: shows a polarization direction at the entrance side of the illumination system;
- FIG. 4b: shows an electric field vector of circularly polarized light;
- FIG. 4c: shows a polarization direction at the exit side of the illumination system;
- FIG. 5: shows an illumination system according to a second embodiment of the invention in an illustration similar to FIG. 2, including liquid crystals as polarization manipulators;
- FIG. 6: shows the rotation of a polarization direction caused by a liquid crystal;
- FIG. 7: shows a graph illustrating the time variation of the rotational angle α;
- FIG. 8: shows an illumination system according to a third embodiment of the invention in an illustration similar to FIG. 2, including half-wave plates as polarization manipulators;
- FIG. 9: shows a graph illustrating the time variation of the rotational angle α for the third embodiment shown in FIG. 8;
- FIG. 10: shows an illumination system according to a fourth embodiment of the invention in an illustration similar to FIG. 2, including a third polarization manipulator and liquid crystals as polarization manipulators;
- FIG. 11: shows a schematic representation of a radial polarization distribution;
- FIG. 12: shows a graph illustrating the time variation of the rotational angle α for the fourth embodiment shown in FIG. 10;
- FIG. 13: shows an illumination system according to a fifth embodiment of the invention in an illustration similar to FIG. 2, including a third polarization manipulator and two removable polarization manipulators;
- FIG. 14: shows an illumination system according to a sixth embodiment of the invention in an illustration similar to FIG. 2, including two pairs of polarization manipulators and a third polarization manipulator located between the pairs;
- FIG. 15: shows an illumination system according to a seventh embodiment of the invention in an illustration similar to FIG. 2, including an actuator for rotating two lenses during operation of the illumination system;
- FIG. 16: shows a section through the illumination system shown in FIG. 15 along line XVI-XVI;
- FIG. 17a: shows a considerably simplified view of a projection exposure apparatus according to a eighth embodiment of the invention in a projection mode;
- FIG. 17b: shows the projection exposure apparatus of FIG. 17a, but in a compensation mode;
- FIGS. 18a: and 18b show the polarization directions at a first point of an optical element in the projection mode and the compensation mode, respectively;
- FIGS. 19a: and 19b show the polarization directions at a second point of the optical element in the projection mode and the compensation mode, respectively;
- FIG. 20: shows a considerably simplified view of a projection exposure apparatus according to a ninth embodiment of the invention, in which compensation of polarization-induced birefringence is carried out during exposure operation of the apparatus;
- FIG. 21: shows a considerably simplified view of an illumination system according to a tenth embodiment of the invention, in which compensation of polarization-induced birefringence is carried out during exposure operation of the apparatus only in the illumination system;
- FIG. 22: shows an illumination system according to an eleventh embodiment of the invention in a first mode of operation, including a third polarization manipulator, an insertable rotator as first polarization manipulator and a rotatable half-wave plate as second polarization manipulator;
- FIG. 23: is a perspective view of the third polarization manipulator illustrated in FIG. 22;
- FIG. 24: is a graph illustrating a thickness profile of the first manipulator shown in FIG. 23 for a d-rotatory optically active crystal;
- FIG. 25: is a graph illustrating a thickness profile of the first manipulator shown in FIG. 23 for a 1-rotatory optically active crystal;
- FIG. 26: shows pupil polarization distributions at various positions along the optical axis in the first mode of operation;
- FIG. 27: shows the illumination system of FIG. 22 in a second mode of operation;
- FIG. 28: shows pupil polarization distributions at various positions along the optical axis in the second mode of operation.

### DESCRIPTION OF PREFERRED EMBODIMENTS

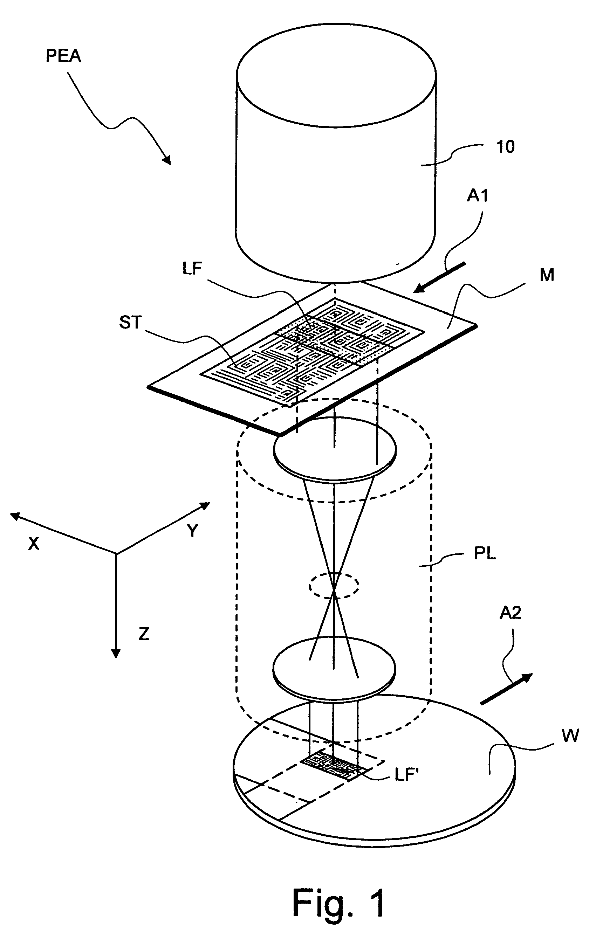

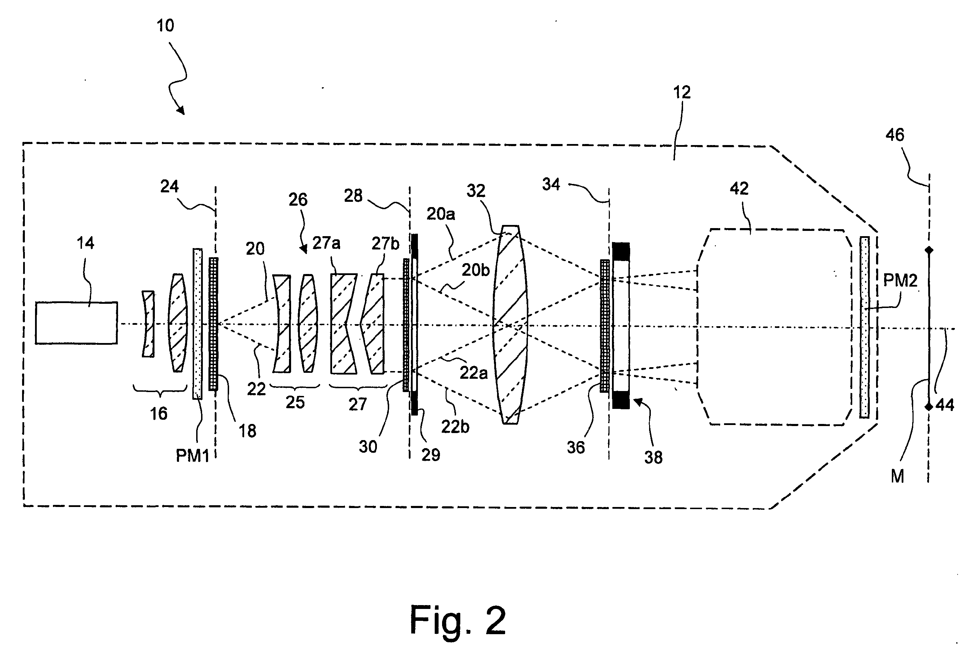

FIG. 1 shows in a perspective and highly simplified view of an exemplary projection exposure apparatus in which the invention can be used. The projection exposure apparatus, which is denoted in its entirety by PEA, comprises an illumination system 10 that produces a projection light bundle and will be further explained with reference to the following FIGS. 2 to 14. The projection light bundle illuminates, in the embodiment shown, a narrow rectangular light field LF on a mask M containing small structures ST. The structures ST within the light field LF are imaged onto a photoresist which is deposited on a wafer W and arranged in an image plane of a projection lens PL. Since the projection lens PL has a magnification of less than 1, a minified image LF' of the structures ST within the light field LF is projected onto the wafer W.

During the projection, the mask M and the wafer W are moved along a scan direction along the Y-axis. The ratio between the velocities of the mask M and the wafer W is equal to the magnification of the projection lens PL. If the projection lens PL inverts the image, the mask M and the wafer W move in opposite directions, as this is indicated in FIG. 1 by arrows A1 and A2. Thus the light field LF scans over the mask M so that also larger structured areas on the mask M can be projected continuously onto the photoresist.

FIG. 2 shows a meridional section of the illumination system 10. For the sake of clarity, the illustration shown in FIG. 2 is considerably simplified and not to scale. This particularly implies that different optical units are represented by very few optical elements only. In reality, these units may comprise significantly more lenses and other optical elements. The illumination system 10 comprises a light source that is, in the embodiment shown, realized as an excimer laser 14. The excimer laser 14 emits projection light that has a wavelength in the deep ultraviolet (DUV) spectral range, for example 193 nm.

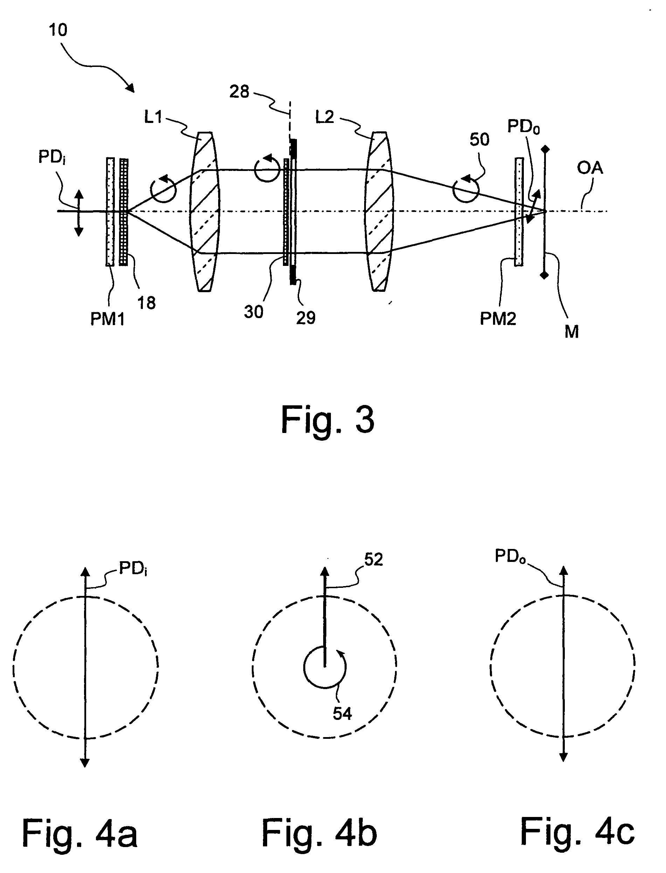

The projection light then enters a beam expansion unit 16 in which the light bundle is expanded. After passing through the beam expansion unit 16 the projection light impinges on a first polarization manipulator PM1 whose function will be explained below with reference to FIGS. 3 and 4a to 4c. After having traversed the first polarization manipulator PM1, the projection light is diffracted by a first diffractive optical element 18. The first diffractive optical element 18 comprises one or more diffraction gratings that deflect each incident ray such that a divergence is introduced. In FIG. 2 this is schematically represented for an axial ray that is split into two diverging rays 20, 22. The first diffractive optical element 18 thus modifies the angular distribution of the projection light. The first diffractive optical element 18 can also be replaced by any other kind of optical raster element, for example a micro-lens array in which the micro-lenses are formed by Fresnel zone plates. Further examples for optical raster elements that are suitable for this purpose are given in the US 6 285 443 whose contents are incorporated herein by reference.

The first diffractive optical element 18 is positioned in an object plane 24 of a first objective 26 that is only indicated by a zoom lens group 25 and a pair 27 of axicon elements 27a, 27b. Reference numeral 28 denotes an exit pupil plane of the first objective 26. In or in close proximity to the exit pupil plane 28 an exchange holder 29 for different optical components is located. These optical components can, when inserted into the exchange holder 29, modify certain optical properties of the light in the pupil plane 28, for example the polarization distribution.

A field defining component 30 in the form of another optical raster element is also positioned in or in close proximity to the pupil plane 28 of the first objective 26. The field defining component 30 introduces a divergence for each point and also influences the geometry of the light field on the mask M. The divergence introduced by the field defining component 30 is schematically represented in FIG. 2 by divergent rays 20a, 20b and 22a, 22b for the impinging rays 20 and 22.

The diverging rays 20a, 20b and 22a, 22b enter a second objective 32 that is represented in FIG. 2 by a single condenser lens 32. The second objective 32 is arranged within the illumination system 10 such that its entrance pupil plane coincides with the exit pupil plane 28 of the first objective 26. The image plane 34 of the second objective 32 is a field plane in which an adjustable stop 38 is positioned. The stop 38 ensures sharp edges of the illuminated light field LF in the scan direction Y. Two this end, a third objective 42 having an object plane that coincides with the image plane 34 of the second objective 32 is arranged along an optical axis 44 of the illumination system 10. In an image plane 46 of the third objective 42 the mask M can be positioned using a mask stage (not shown). Between the third objective 42 and the mask M a second polarization manipulator PM2 is located.

FIG. 3 is an even more simplified illustration of the illumination system 10 shown in FIG. 2. The zoom lens group 25 and the axicon pair 27 are commonly represented by a single lens L1, whereas all optical elements between the exchange holder 29 and the second polarization manipulator PM2 are represented by a single lens L2.

In the embodiment shown in FIG. 3 it is assumed that the laser 14 produces linearly polarized light having a polarization direction that is parallel to the plane of the sheet and indicated in FIG. 3 by a double arrow PDᵢ. The polarization manipulator PM1 is a quarter-wave plate which is oriented with respect to an optical axis OA of the illumination system 10 such that a principal axis of the quarter-wave plate forms an angle of 45° with the polarization direction PDᵢ of the incident light. As a result, the light emerging from the polarization manipulator PM1 is circularly polarized. In FIG. 3 this is indicated for a single ray R by circular arrows 50.

It is further assumed that the optical elements between the first polarization manipulator PM1 and the second polarization manipulator PM2, namely the lenses L1 and L2 and the second diffractive optical element 30, maintain this circular polarization until the ray R impinges on the second polarization manipulator PM2. The second polarization manipulator PM2 is a three-quarter-wave plate which is oriented with respect to the optical axis OA such that a principal axis forms an angle of 45° with respect to the polarization direction PDᵢ. Thus the polarization manipulator PM2 transforms the circular polarization state of the ray R back into a linear polarization state which is indicated in FIG. 3 by a double arrow PDₒ. Since the polarization direction has not been rotated around the propagation direction of the ray during its passage through the illumination system 10, the polarization states of the ray R before entering the first polarization manipulator PM1 and after emerging from the second polarization manipulator PM2 are identical.

The polarization states of the ray R within the three sections, into which the two polarization manipulators PM1, PM2 divide the illumination system 10, are diagrammatically illustrated in FIGS. 4a, 4b and 4c:

FIGS. 4a and 4c show the polarization directions PDᵢ and PDₒ in a plane which is perpendicular to the propagation direction of the ray R. FIG. 4b shows the electric field vector 52 for the ray R between the first and second polarization manipulators PM1 and PM2. The electric field vector 52 describes a circular movement around the direction of propagation which is indicated in FIG. 4b by a circular arrow 54. The direction of the rotation of the electric field vector 52 depends on the angular relationship between the principal axes of the quarter-wave plate contained in the first polarization manipulator PM1 and the polarization direction PDᵢ of the incident light.

Due to the fast rotation of the electric field vector 52, all points along the path of the ray R through the lenses L1 and L2 and the second diffractive optical element 30 experience an even distribution of polarization directions. Since there is no preferred polarization direction, the high intensity light emitted by the laser 14 cannot cause unevenly distributed density variations in the optical materials which finally result in optical birefringence. This does not imply that the materials do not undergo any degradation caused by the high intensity light at all. However, these degradations are isotropic so that the optical properties of the materials change, if any, isotropically as well. Therefore polarization-induced birefringence, which is an anisotropic effect, cannot occur within all optical elements located between the two polarization manipulators PM1 and PM2.

It is to be understood that the embodiment explained so far may be modified in various ways. For example, if the illumination system 10 shall provide not the identical, but a different linear polarization state at its exit side, this may be achieved, for example, by an additional half-wave plate oriented appropriately. Such a half-wave plate could also be incorporated into the second polarization manipulator PM2 so as to form one single element. For example, if the polarization states at the input and the exit side of the illumination system 10 shall be orthogonal, the first and the second polarization manipulator PM1 and PM2 may both be quarter-wave plates or both be three-quarter-wave plates.

Further, it is not absolutely necessary that the polarization state of the ray R between the two polarization manipulators PM1 and PM2 is exactly circular. In many cases a slightly elliptical polarization state may also prevent the occurrence of polarization-induced birefringence to a very good extent. The degree of ellipticity which can be tolerated depends on the required lifetime of the optical elements between the polarization manipulators PM1 and PM2.

Still further, since the divergence of the projection light increases after each diffractive optical element 18 and 30, the wave plates used as polarization manipulators PM1 and PM2 may differ with respect to the number of phase shifts by 360° introduced by each element. Since the angles formed between the optical axis and rays emanating from the first diffractive optical element 18 are comparatively small, also a multi-order quarter-wave plate may be used for the first polarization manipulator PM1. Behind the second diffractive optical element 30 these angles are usually significantly larger. It may therefore be necessary to use a zero-order, a quasi-zero-order or at least a low order wave plate as the second polarization manipulator PM2.

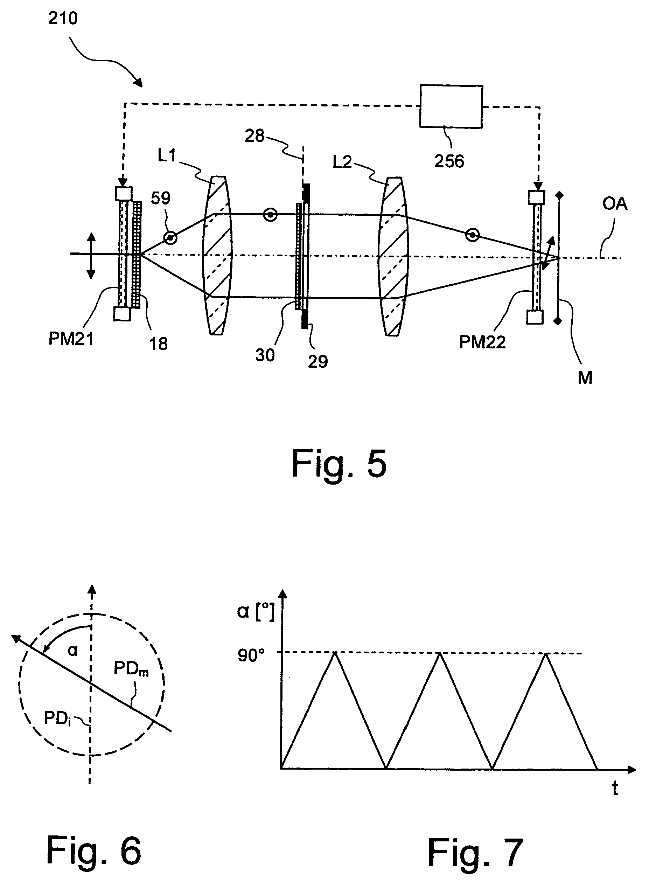

FIG. 5 shows a second embodiment for an illumination system in an illustration similar to FIG. 3. The illumination system shown in FIG. 5, which is denoted in its entirety by 210, comprises polarization manipulators PM21 and PM22 that differ from the polarization manipulators PM1, PM2 of the first embodiment in that the polarization manipulators PM21, PM22 are liquid crystals displaying the effect of optical activity. Materials are referred to as optical active if the plane of vibration of a ray of linear light undergoes a continuous rotation as the ray propagates along a certain axis of the material. With some optical active materials, the angle of rotation does not only depend on the length of the path within the material, but also on an electric field to which the liquid crystal is exposed. This approach of controlling the angle of rotation is commonly exploited, for example, in commonplace liquid crystal displays (LCD).

The polarization manipulators PM21 and PM22 of the illumination system 210 therefore each contain, in addition to a liquid crystal, a pair of electrodes so that each liquid crystal may be exposed to a more or less homogeneous electric field. The field strength can be varied by modifying a control voltage using a control unit 256.

The function of the illumination system 210 will be explained in the following with reference to FIGS. 6 and 7. FIG. 6 shows as a continuous line the polarization direction PDₘ of the ray R after having emerged from the first polarization manipulator PM21. The polarization direction PDm has been rotated around the direction of propagation by an angle α with respect to the polarization direction PDᵢ of the ray R before entering the first polarization manipulator PM21. Since there are no optical elements between the two polarization manipulators PM21, PM22 that modify the polarization state, the ray R impinges on the second polarization manipulator PM22 still having the rotated polarization direction PDₘ.

The control unit 256 applies such a voltage to the liquid crystal contained in the second polarization manipulator PM22 that the original polarization state will be restored. Thus the light impinging on the mask M has the same polarization state as the light incident on the first polarization manipulator PM21. In order to avoid that optical material between the polarization manipulators PM21, PM22 becomes birefringent, the angle α is varied during the operation of the illumination system 210.

There are many different possibilities how this variation may be realized.

FIG. 7 shows a diagram in which the angle of rotation α is shown as a function of time t. In this example, the control unit 256 controls the voltage applied to the liquid crystal in the first polarization manipulator PM21 in such a way that the polarization direction is linearly increased to 90°, linearly reversed to 0°, again increased to 90° and so on. In FIG. 5 the polarization direction rotated by 90° (i.e. orthogonal to the plane of the sheet) is indicated by symbols 59. As a result of this time variation, the rotational angles are evenly distributed between 0° and 90°. This range of angles α is sufficient since the slow axis in a birefringent material is orthogonal to the fast axis. If the polarization direction sweeps over this range of angles between 0° and 90°, no fast or slow axis can be "burned" into the material by the linearly polarized ray R.

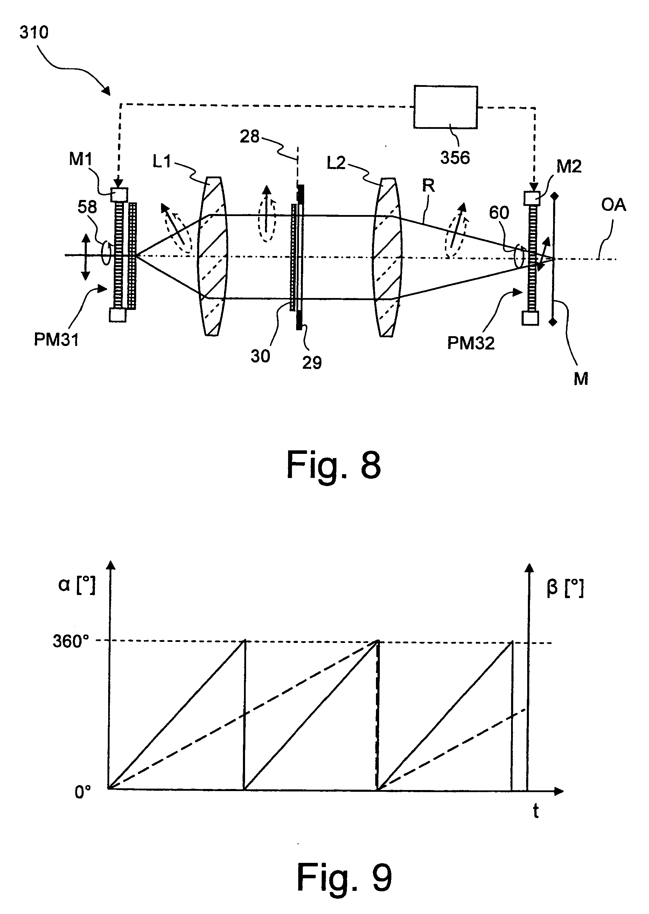

FIG. 8 shows a third embodiment of an illumination system which is denoted in its entirety by 310. In the illumination system 310 polarization manipulators PM31, PM32 are used which each contain a half-wave plate and an actuator for rotating the half-wave plate around the optical axis OA by a rotational angle α. The actuators are indicated in FIG. 8 by two motors M1, M2. The rotation of the half-wave plates is indicated in FIG. 8 by circular arrows 58, 60.

As has already been mentioned above, a half-wave plate has the effect of rotating the polarization direction of linearly polarized light by an angle α. The angle α has twice the size of the angle between a principal axis of the half-wave plate and the polarization direction of the incident light. Also in this embodiment, the half-wave plate of the second polarization manipulator PM32 is oriented such that the original polarization direction is restored. If the control unit 356 controls the motors M1, M2 such that they synchronously rotate the half-wave plates by angles in the range between 0° and 45°, the same effect may be achieved as shown in FIG. 7 for the second embodiment.

FIG. 9 shows a diagram similar to the one shown in FIG. 7. A continuous line represents the variation of the angle α, by which the polarization state is rotated in the first polarization manipulator PM31, during the operation time t of the illumination system 310. The angle β, by which the half-wave plates are rotated, is shown in broken lines. If both half-wave plates are continuously rotated in the same direction, this results in a rotation of the polarization direction PDₘ between the two polarization manipulators PM31 and PM32 with twice the angular frequency of the half-wave plates.

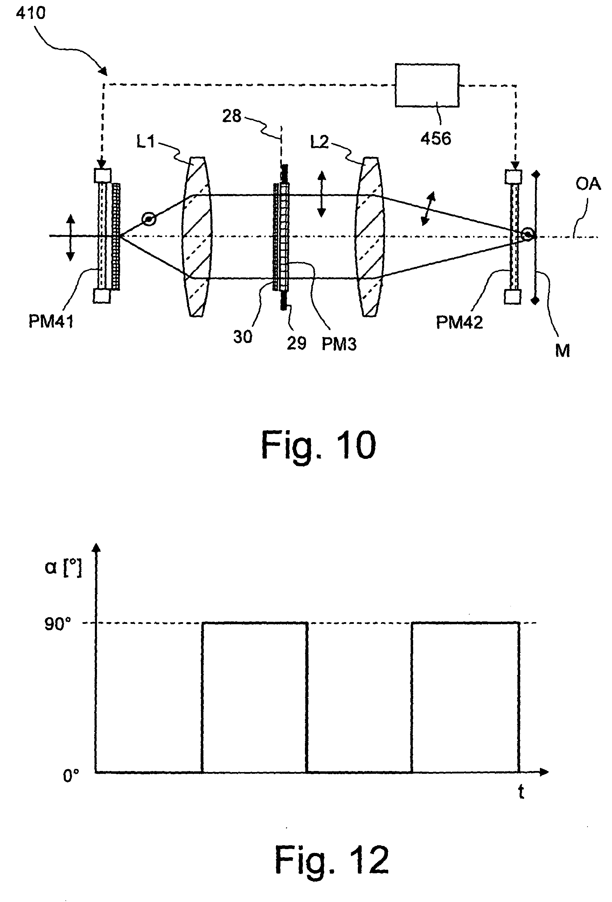

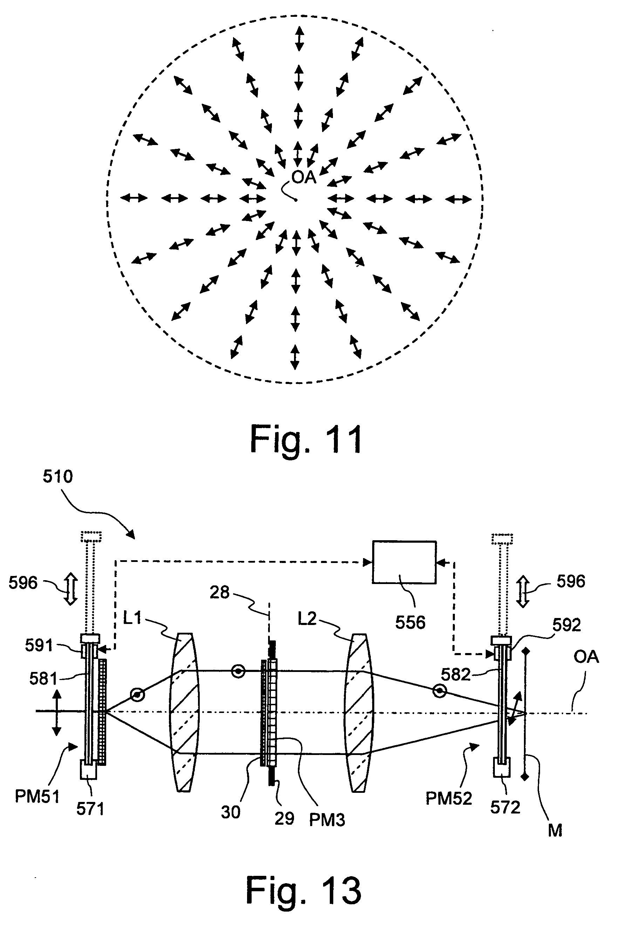

FIG. 10 shows an illumination system according to a fourth embodiment which is denoted in its entirety by 410. The illumination system 410 differs from the illumination system 210 only in that a third polarization manipulator PM3 is inserted into the exchange holder 29. The third polarization manipulator PM3 transforms a homogenous linear polarization distribution into a radial polarization distribution as it is schematically shown in FIG. 11. The radial polarization distribution differs from a homogenous linear distribution in that, although each ray is linearly polarized, the polarization directions differ depending on the position where the ray R passes through the third polarization manipulator PM3. For each position the polarization direction points towards the optical axis running through the center of the third polarization manipulator PM3.

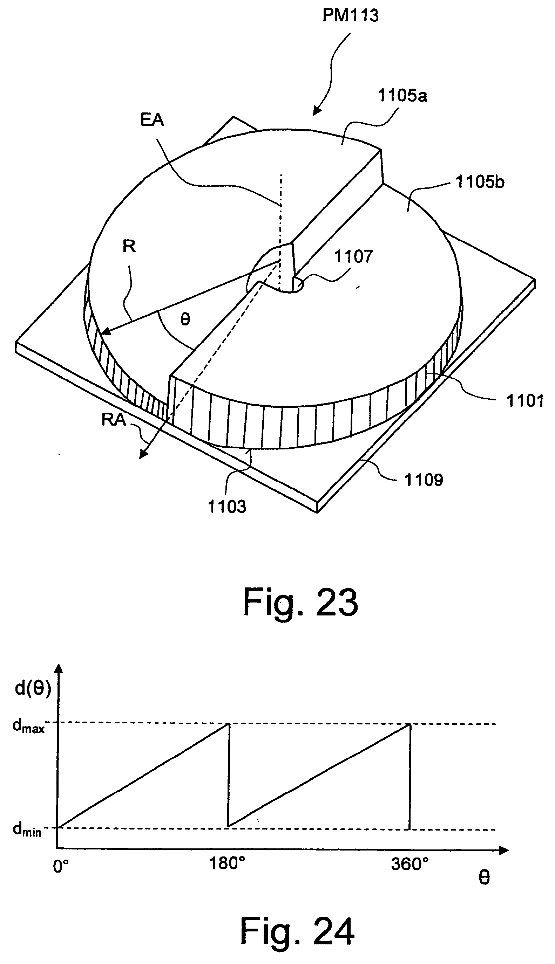

To this end, the third polarization manipulator PM3 may comprise a plurality of hexagonal half-wave plates that are distributed over the area of the element. Further details of such a polarization manipulator are described in US Patent No. 6 392 890 B2 whose contents are incorporated herein by reference. Another optical element that can be used as third polarization manipulator PM3 is disclosed in US Patent Application Ser. No. 60/537 327 will be briefly described further below with reference to FIGS. 23 to 25. The full disclosure of this earlier application is incorporated herein by reference.

Since the third polarization manipulator PM3 requires a defined and homogenous linear polarization state at its input side, it is not possible to continuously rotate the polarization direction in the manner shown in FIG. 7. However, if liquid crystals contained in polarization manipulators PM41 and PM42 are controlled by the control unit 456 such that they both synchronously switch between rotational angles of 0° and 90°, as is diagrammatically shown in FIG. 12, the third polarization manipulator PM3 is either exposed to light having the original homogenous linear polarization state or a homogenous linear polarization state which is orthogonal to the original one.

If the polarization direction is unaltered by the first polarization manipulator PM41, the third polarization manipulator PM3 produces a tangential polarization distribution. Since the second polarization manipulator PM42 does not rotate the polarization direction, the mask M is illuminated with light having a tangential polarization state. If, however, the first polarization manipulator PM41 rotates the polarization direction by 90°, the third polarization manipulator PM3 produces a radial polarization distribution. This radial polarization distribution, in which all polarization directions run in radial directions, is then subjected to another rotation by 90° in the second polarization manipulator PM42. This again results in the desired tangential polarization distribution (see FIG. 10).

Therefore the illumination system 410 rotates the polarization direction not continuously, but intermittently by discrete values of 90°. This is still sufficient for preventing birefringence in the optical materials between the polarization manipulators PM41 and PM42. The reason is that the density variations induced by two light rays having orthogonal linear polarization directions are orthogonal as well. Therefore birefringence cannot occur in the optical materials so that two orthogonal polarization states will always experience the same index of refraction.

The use of liquid crystals as polarization rotators is particularly advantageous in this embodiment because liquid crystals allow to rotate the polarization direction almost instantly. Thus it is possible to rotate the polarization direction between the polarization manipulators PM41 and PM42 even in the short interruptions between subsequent exposures.

Another, although somewhat slower approach of intermittently rotating the polarization direction by 90° is shown in FIG. 13. In this illumination system according to a fifth embodiment, which is denoted in its entirety by 510, two polarization manipulators PM51, PM52 are provided that each comprise an exchange holder 571 and 572, respectively, a half-wave plate 581 and a rotator 582 comprising two half-wave plates, respectively, and an actuator 591 and 592, respectively. The actuators 591, 592 are connected to a control unit 556 that allows to control the actuators 591, 592 in such a way that the half-wave plate 581 and the rotator 582 can be inserted into and removed from the exchange holders 571 and 572, respectively, as is indicated in FIG. 13 by arrows 596.

If the half-wave plate 581 and the rotator 582 are in a position outside the path of the rays, as it is shown in FIG. 13 by dotted lines, the homogenous linear polarization state provided by the laser 14 will be maintained until the light impinges on the third polarization manipulator PM3. There the homogenous polarization distribution is transformed into a tangential polarization distribution as has been explained above with reference to FIG. 10 and 11. Since the second half-wave plate 582 is also outside the path of the rays, the projection light will impinge on the mask M with this tangential polarization distribution.

Upon a control command of the control unit 556, the actuators 591, 592 move the half-wave plate 581 and the rotator 582 into the exchange holders 571 and 572, respectively. The principal axis of the half-wave plate 581 is arranged such that it causes a rotation of the polarization direction by 90°. The rotator 582 rotates is configured to rotate the polarization direction by 90°. The effect is the same as the one achieved by rotating the polarization directions using liquid crystals which has been explained above with reference to FIGS. 10 to 12.

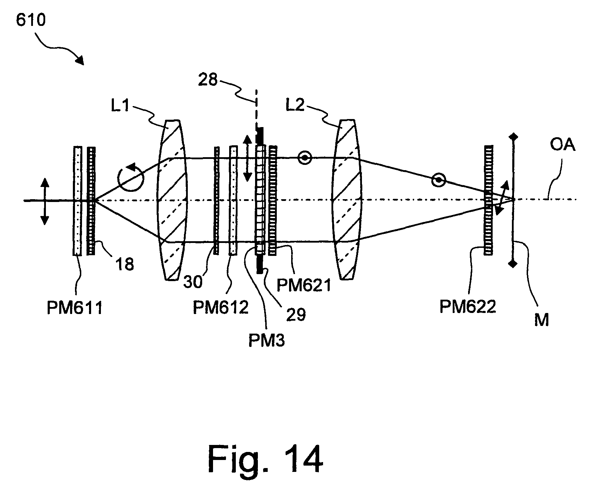

FIG. 14 shows an illumination system 610 according to a sixth embodiment. The illumination system 610 also comprises a third polarization manipulator PM3 which is inserted into the exchange holder 29. In contrast to the embodiments described above, the illumination system 610 comprises two pairs of polarization manipulators, namely a first pair of manipulators PM611 and PM612 and a second pair of manipulators PM621 and PM622. A third polarization manipulator PM3 is arranged between the two pairs of polarization manipulators so that it is not affected by any time variations of the direction in which the electric field vector oscillates. Thus the polarization distribution of the projection light bundle immediately in front of the third polarization manipulator PM3 can have always the form that is required by the third polarization manipulator PM3.

Each pair of the polarization manipulator PM611, PM612 and PM621, PM622 may be realized according to any ones of the aforementioned embodiments. In the embodiment shown, the polarization manipulators PM611, PM612 of the first pair each comprise a quarter-wave plate and a three-quarter-wave plate in the manner as has been explained above with reference to the first embodiment shown in FIG. 3. The polarization manipulators PM621, PM622 of the second pair of polarization manipulators each comprise two half-wave plates that are arranged such that principal axes of both plates form an angle of 45° in between. Such a combination of two half-wave plates ensures a rotation of the polarization direction by 90° even if the polarization direction of the incident light is unknown or varying.

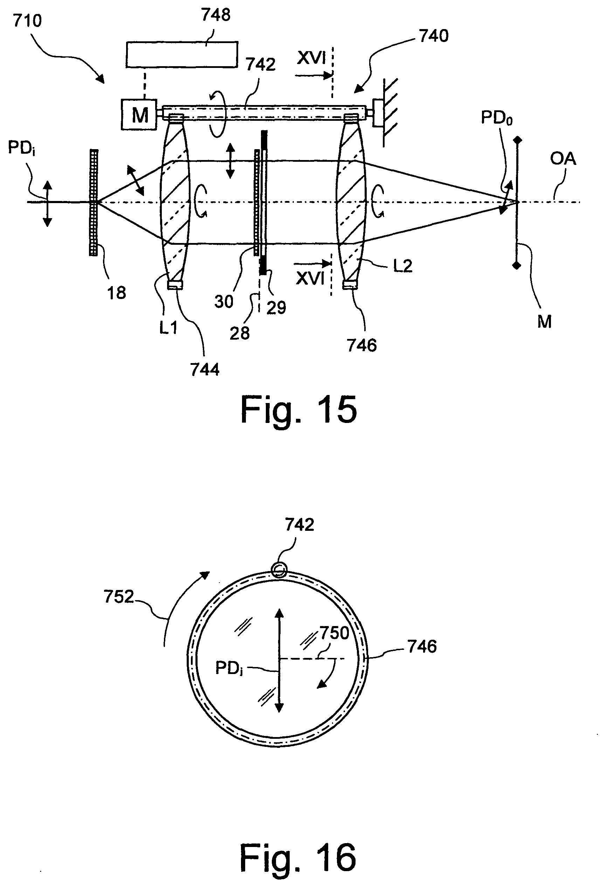

FIG. 15 shows an illumination system 710 according to a seventh embodiment of the invention. Instead of having polarization manipulators, the illumination system 710 comprises an actuator which is denoted in its entirety by 740. The actuator 740 allows to rotate the lenses L1, L2 around their common axis of rotational symmetry that coincides with the optical axis OA.

To this end, the actuator 740 comprises a toothed roller 742 that is driven by a motor M. Toothed wheel rims 744, 746 are attached to the outer circumference of the lenses L1, L2. The toothed wheel rims 744, 746 form, together with the toothed roller 742, a toothed wheel-work that provides a transmission between the motor M and the lenses L1, L2. Actuation of the motor M therefore results in a simultaneous rotation of the lenses L1, L2 around their common axis of symmetry.

The motor M is connected to a control unit 748 that allows to control the motor M according to a predetermined control pattern. In the embodiment shown, this pattern is set so that the lenses L1, L2 are rotated continuously and slowly during the exposure operation of the illumination system 710. This ensures that linearly polarized light having a polarization direction PDᵢ cannot cause polarization-induced birefringence in the materials from which the lenses L1, L2 are made. This is because, due to the continuous rotation of the lenses L1, L2, there is no fixed spatial relationship between the polarization direction PDᵢ and the material of the lenses L1, L2.

The control unit 748 may control the motor M alternatively in such a way that the lenses L1, L2 are rotated only during pauses between exposure operation intervals of the illumination system 710. This can be advantageous in those cases in which the optical elements have not a rotational symmetry but only a manifold symmetry. This means that the shape of the optical element remains invariant not under rotations by arbitrary angles, but only by certain angles, for example 90°. In this case the optical properties of the optical element will remain the same only if it rotated by specific angles. Rotating the optical element in pauses may also be advantageous if only the shape of the optical element, but not the material as such (e.g. its crystal structure) has a rotational symmetry.

If the lenses L1, L2 are not continuously rotated during the operation of the illumination system, it may not be possible to completely prevent polarization-induced density variations that eventually result in birefringence. However, it is possible to achieve at least substantially symmetrical density variations, if the lenses L1, L2 are rotated by 90° or uneven multiples thereof by the help of the actuator 740.

This situation is illustrated in FIG. 16 that shows a section through the illumination system 710 along line XVI-XVI. The double arrow PDᵢ indicates the polarization direction of the incident light. Reference numeral 750 indicates a reference direction fixedly associated with the lens L2. If the lenses L1, L2 are rotated by a rotational angle of 90° during a pause between operation intervals of the illumination system 710, as is indicated by an arrow 752, the lens L2 (and also lens L2) will be exposed to the incident light during the subsequent operation interval such that the reference direction 750 coincides with the polarization direction PDi. This will induce density variations as before, however with orthogonal directions. If the duration of the operation intervals in the two angular positions are approximately the same, no birefringence will occur.

It is to be understood that various other control patterns are possible for the control of the motor M. For example, the lenses L1, L2 could be intermittently rotated by rotational angles of 10° during the operation of the illumination system 710 until the lenses L1, L2 have been rotated by an overall angle of 90°. Then the same procedure could be reversed until the lenses L1, L2 have returned to their original position. A kind of "blurring" of polarization-induced density variations may even be achieved if the maximum angle of rotation is less than 45°. This may be sufficient to suppress the occurrence of polarization-induced birefringence.

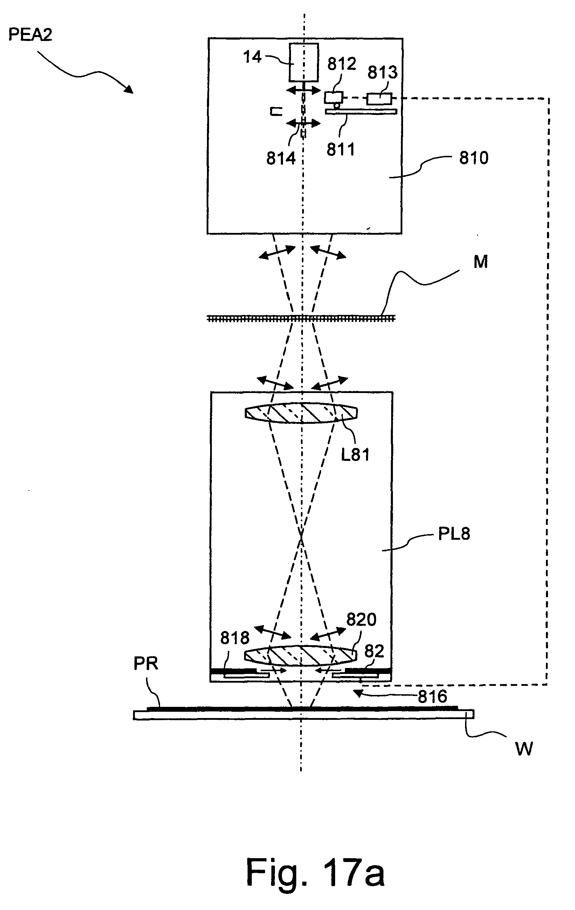

FIG. 17a shows in greatly simplified manner a projection exposure apparatus PEA2 according to an eighth embodiment of the invention in a meridional section.

The projection exposure apparatus PEA2 differs from the projection exposure apparatus PEA shown in FIGS. 1 and 2 in that the illumination system denoted by 810 additionally comprises half-wave plate 811 that can be inserted into a path of light rays emitted by the laser 14. To this end, an actuator 812 is provided within the illumination system 810 whose function is controlled by a control unit 813. The half-wave plate 811 is oriented with respect to a polarization direction of the emitted light (see double arrows 814) such that this polarization direction is rotated by 90° if the half-wave plate 811 is inserted into the path of the rays.

The projection exposure apparatus PEA2 further comprises a shutter that is denoted in its entirety by 816. The shutter 816 is arranged between a last lens L82 of the projection lens PL8 and the photoresist PR and comprises two movable blades 818, 820 that can be moved with the help of an appropriate actuator (not shown) into the path of the rays. Since shutters for projection exposure apparatus are generally known in the art, it will not be discussed in further detail here.

FIG. 17a shows the projection exposure apparatus PEA2 in the projection mode. This means that the linear polarization of the light rays emitted by the laser 14 is maintained throughout the optical parts of the projection exposure apparatus PEA2 until the rays impinge on the photoresist PR. In the course of the operation with this fixed linear polarization state, polarization-induced density variations may occur at least in some optical elements arranged between the laser 14 and the photoresist PR. Without any compensation, these density variations would eventually result in birefringence.

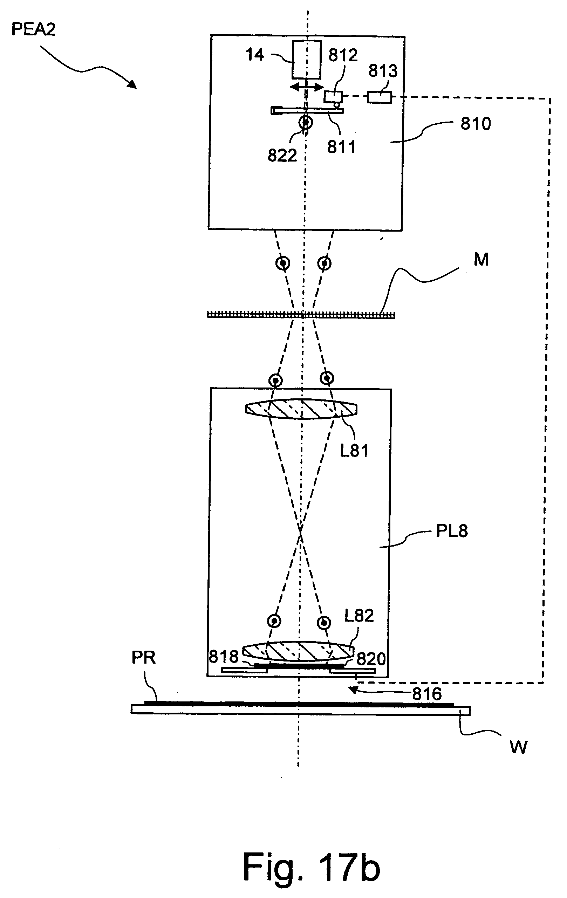

FIG. 17b shows the projection exposure apparatus PEA2 in a compensation mode. In the compensation mode the half-wave plate 811 is inserted, by means of the actuator 812, into the path of the rays such that the originally polarization direction is rotated by 90°. This rotated polarization direction is indicated in FIG. 17b by the symbol 822. On the assumption that this polarization direction is not significantly altered while the rays traverse the various optical elements arranged in the illumination system 810 and the projection lens PL8, the light emitted by the laser 14 now serves as compensation light that induces compensating density variations. This means that the density variations induced by the light rays in the compensation mode are aligned orthogonal to the density variations induced in the projection mode. If the projection exposure apparatus PEA2 is operated in the projection mode and the compensation mode with approximately equal durations, no birefringence can occur.

In order to prevent the light in the compensation mode from impinging on the photoresist PR, the shutter 816 is operated so that light that has passed the last lens L82 cannot exit the projection lens PL8. The shutter 816 is connected to the control unit 813 so that its operation can be synchronized with the insertion of the half-wave plate 811 in the illumination system 810.

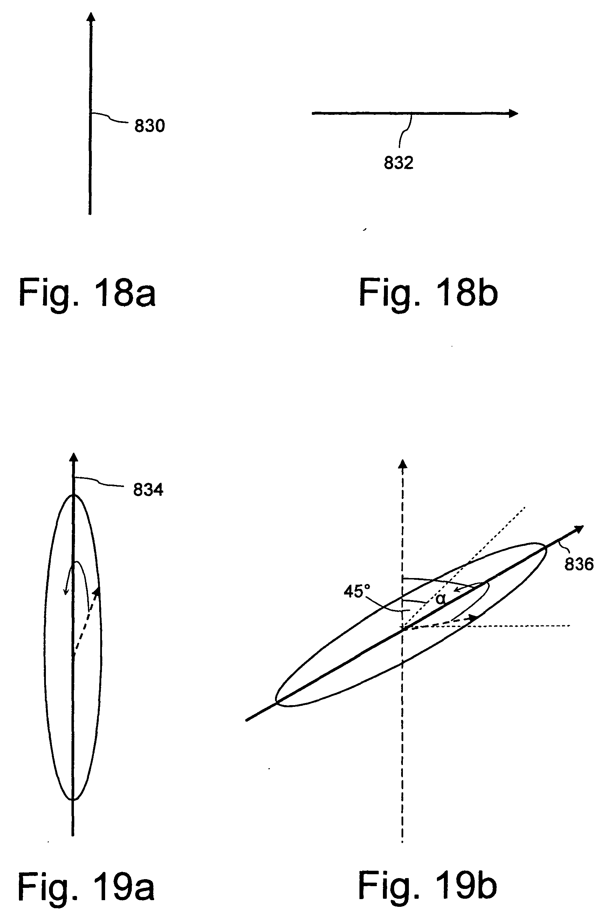

FIGS. 18a and 18b show polarization directions 830, 832 of the light rays on a particular point on the last lens L82 in the projection mode and the compensation mode, respectively. As can be clearly seen, the light rays incident on the particular point are all linearly polarized having the same polarization direction. In the compensation mode, all polarization directions are rotated by 90° so that the particular point is exposed to linearly polarized light having an orthogonal polarization direction if compared with the projection mode.

At a second point of the lens L82 the physical conditions may be more complicated, as is shown in FIGS. 19a and 19b. Here it is assumed that rays traversing the second point combine such that the resulting polarization state can be described as elliptically polarized with a dominant overall polarization direction 834. The overall polarization direction is in this case the direction of the longer axis of the ellipse. Such deviations from the linear polarization state can be caused, for example, by intermediate birefringent optical elements. In FIG. 19a the ellipticity of the polarization state is supposed to be large enough to induce density variations.

FIG. 19b shows the situation at the second point in the compensation mode. Here the overall polarization state is still elliptical, but the dominant overall polarization direction, which is given by the long axis of the ellipse and which is indicated in FIG. 19b by an arrow 836, is now rotated by an angle α which is larger than 45°. This deviation from the angle of 90° introduced by the half-wave plate 811 may also be caused by intermediate birefringent optical materials. However, since the dominant overall polarization direction 834 in the projection mode is rotated by more than 45°, there is still a compensating effect in the compensation mode.

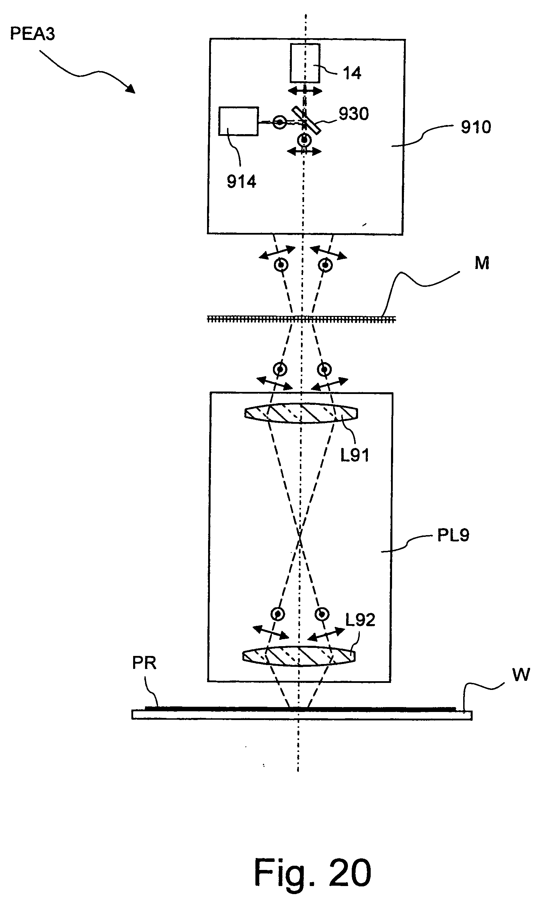

FIG. 20 shows a ninth embodiment of a projection exposure apparatus which is denoted by PEA3. The projection exposure apparatus PEA3 comprises an additional laser 914 that emits compensation light having a wavelength for which the photoresist PR is not sensitive. Thus the compensation can be carried out during the normal exposure operation of the apparatus PEA3. To this end, the light emitted by the additional laser 914 has a polarization direction that is orthogonal to the direction of the light emitted by laser 14. The light rays emitted by the laser 14 and the additional laser 914 are combined with the help of combiner 930 realized as a one-sided mirrored element.

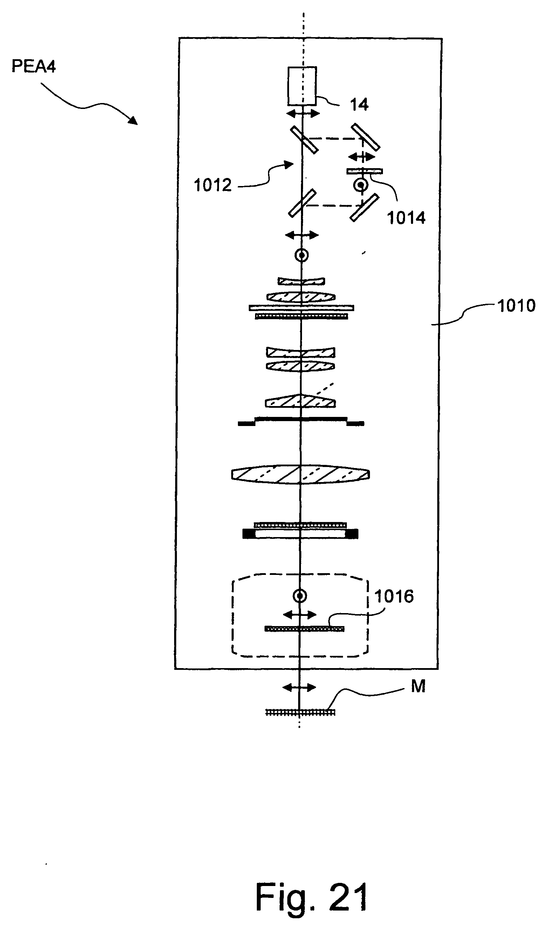

FIG. 21 shows a considerably simplified view of an illumination system according to a tenth embodiment of the invention in a representation similar to FIG. 2. The illumination system 1010 of the projection exposure apparatus PEA4 comprises an arrangement 1012 including one-sided mirrored divider and combiner elements, plane mirrors and a half-wave plate 1014. This arrangement 1012 splits off about one half of the incident light intensity, rotates its polarization direction by 90°, and combines this branch with the original light whose polarization direction has not been changed. As a result, light emerging from the arrangement 1012 contains two linear polarization states with orthogonal polarization directions. This ensures that no polarization-induced birefringence can occur in subsequent optical elements within the illumination system 1010. Before the light impinges on the mask M, one of the polarization directions is removed from the projection light by a polarizing filter 1016.

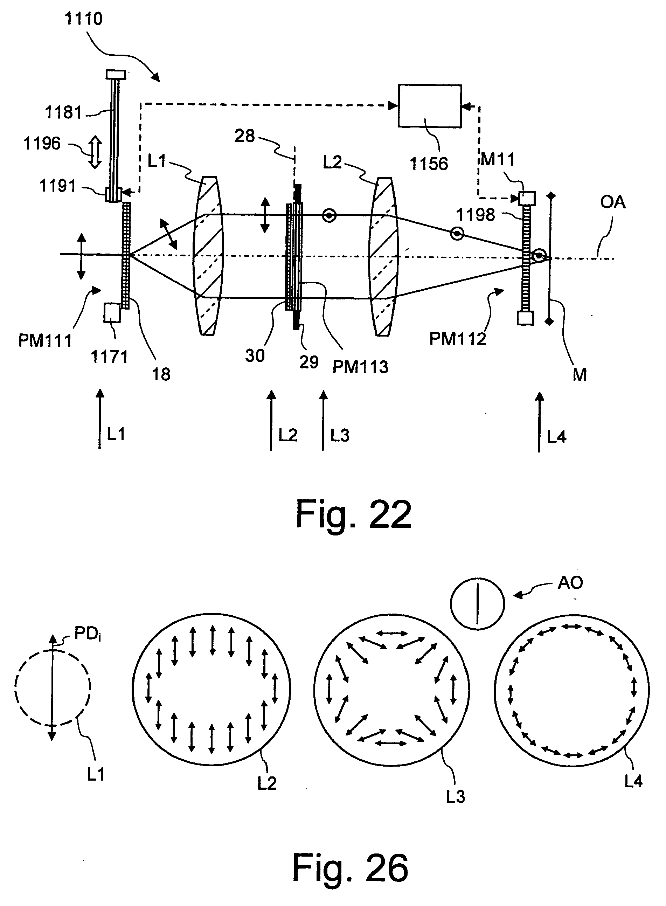

FIG. 22 shows an illumination system according to an eleventh embodiment in a first mode of operation. The illumination system, which is denoted in its entirety by 1110, comprises, similarly to the illumination systems shown in FIGS. 8 and 10, a third polarization manipulator PM113 and is intended to produce a tangential polarization distribution. However, the third polarization manipulator PM113 produces neither a radial nor a tangential polarization distribution, as will become apparent further below. First, the construction of the third polarization manipulator PM113 will be described with reference to FIGS. 23 to 25.

The third polarization manipulator PM113, which is shown in a perspective view in FIG. 23, comprises a crystal 1101 displaying the effect of optical activity. For wavelengths in the range between about 180 nm and 800 nm, crystalline quartz (SiO₂) may be used for the crystal 1101. For longer wavelengths, other crystals such as AgGaS₂ or TeO₂ may be used. If a linearly polarized light ray propagates through a quartz crystal parallel to its optic axis, the polarization direction will be rotated clockwise or anti-clockwise, depending on the crystallographic structure. In the embodiment shown it is assumed that the quartz crystal rotates the polarization direction clockwise. A material introducing a right-handed rotation is commonly referred to as d-rotatory. The rotatory power of crystalline quartz is, at a wavelength of 193 nm, 325.2±0.5 °/mm.

If a linearly polarized light propagates through an optically active crystal parallel to its optic axis, the polarization direction will be rotated by an angle that only depends on the geometrical path length that has been passed by the light ray within the crystal. If different light rays shall be rotated by different angles, this may be achieved by selecting an appropriate thickness profile of the crystal 1101. It should only be ensured that the light rays propagate through the crystal at least approximately parallel to its optic axis. Since the light rays passing the pupil plane 28 typically form small angles with the optical axis OA of the illumination system 1110, this means that the optic axis of the crystal should be is aligned parallel to the optical axis OA.

In the embodiment shown in FIG. 23, the crystal 1101 has substantially the shape of a disc having a plane base surface 1103 and, on the opposite side, a top surface that is divided into two areas 1105a and 1105b. An element axis EA of the third polarization manipulator EM113 is aligned parallel to the optic axis 1101 and coincides with the optical axis OA of the illumination system 1110. Perpendicularly to the element axis EA a reference axis RA may be defined that intersects the element axis EA and serves as a reference axis for an azimuth angle θ. In the illustration of FIG. 23, the two areas 1105a, 1105b are assigned to the azimuth angle ranges 0° to 180° and 180° to 360°, respectively.

Along any arbitrary radius R, which is perpendicular to the element axis EA and forms an angle θ with reference axis RA, the crystal 1101 has a constant thickness d. The term "thickness" relates to the extent of the crystal 1101 along its optic axis. Thus the thickness profile of the crystal 1101 is solely a function of the azimuth angle θ, but not of the radial distance from the element axis EA.

In the center of the crystal 1101 a bore 1107 is provided that simplifies the manufacture of the crystal 1101. The third polarization manipulator PM113 further comprises a mount 1109 that supports the crystal 1101.

FIG. 24 is a graph illustrating the thickness profile d(θ) of the crystal 1101 across the azimuth angle range θ = 0° to θ = 360°. As can be seen in FIG. 24, the thickness linearly increases between the angles θ = 0° and θ = 180° from a minimum thickness value dₘᵢₙ to a maximum thickness value dₘₐₓ. This part of the crystal 1101 corresponds to the area 1105a of the top surface. At the angle θ = 180° there is a step in the thickness profile, because at this angle the thickness drops from dₘₐₓ to dₘᵢₙ and then again linearly increases from dₘᵢₙ to dₘₐₓ until the angle θ = 360° is reached. This second part corresponds to the second area 1105b. At the angle θ = 360°, i.e. between the areas 1105b and 1105a, there is again a step in the thickness profile.

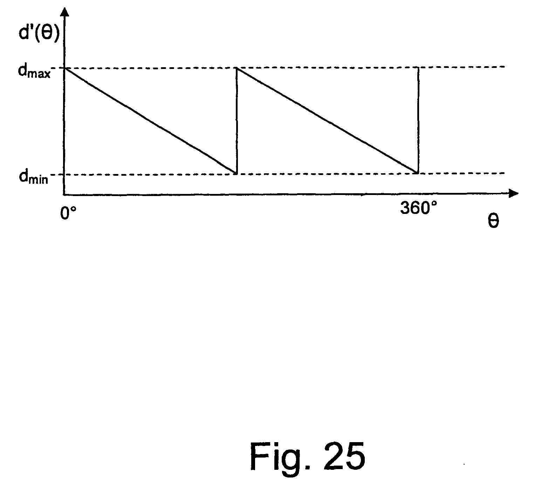

FIG. 25 is a graph showing an alternative thickness distribution d'(θ). This thickness distribution d'(θ) achieves the same physical effect as the thickness distribution d(θ) shown in FIG. 24 for the case that the crystal 1101 is not d-rotatory, but 1-rotatory, i.e. rotating the polarization direction of a transiting light ray anti-clockwise. This is due to the effect that reducing an anti-clockwise rotation with increasing azimuth angle θ, as is shown in FIG. 25, effectively means to increase a clockwise rotation, as is shown in FIG. 24.

Referring back again to FIG. 22, the illumination system 1110 further comprises a first polarization manipulator PM111 including an exchange holder 1171, a rotator 1181 and an actuator 1191. The actuator 1191 is connected to a control unit 1156 that allows to control the actuator 1191 in such a way that the rotator 1181 can be inserted into and removed from the exchange holder 1171, as is indicated in FIG. 22 by a double arrow 1196.

The rotator 1181 comprises, in the embodiment shown, an optically active crystal having a constant thickness that is determined such that a rotation of the polarization direction by 90° is achieved. Alternatively, the rotator 1181 may comprise a single half-wave plate with its optic axis forming an angle of 45° with respect to the initial polarization direction of the incident light.

The second polarization manipulator PM112 comprises a half-wave plate 1198 and a motor M11 for rotating the half-wave plate 1198 by at least 45° around the optical axis OA of the illumination system 1110. The motor M11 is controlled by the control unit 1156.

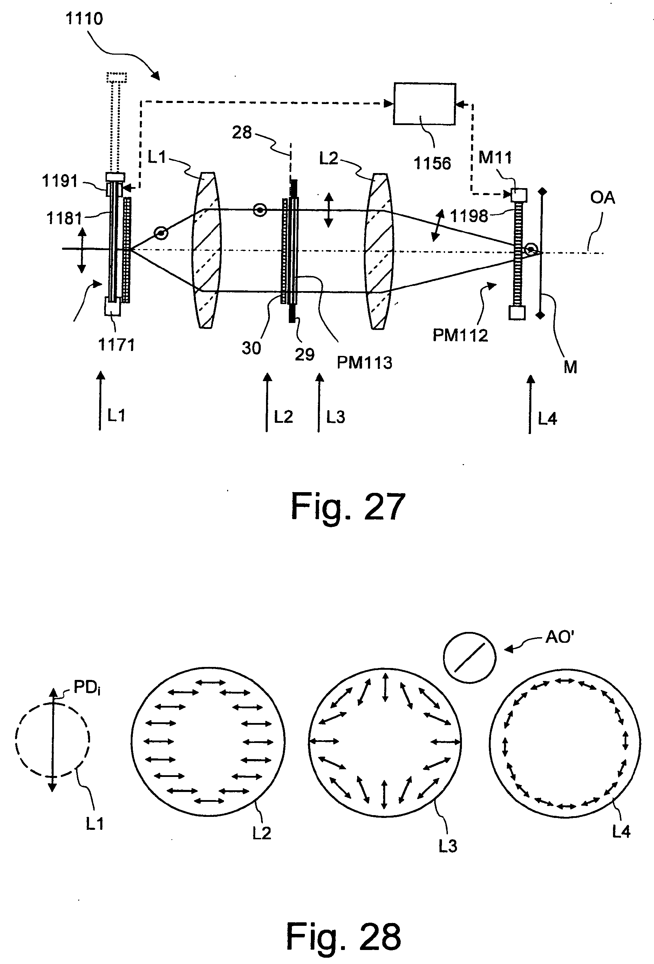

In the first mode of operation that is shown in FIG. 22, the rotator 1181 is retracted from the exchange holder 1171 such that the incident light maintains its initial polarization direction PDᵢ. This is shown in FIG. 26 that graphically illustrates the polarization distributions across the pupil at various locations L1, L2, L3 and L4 along the optical axis OA of the illumination system 1110. As is indicated in FIG. 22 by arrows, references numeral L1 denotes a position immediately in front of the first polarization manipulator PM111. Reference numerals L2 and L3 correspond to positions immediately in front of and behind, respectively, the third polarization manipulator PM113. Reference numeral L4 corresponds to a position immediately behind the second polarization manipulator PM112.

It is now assumed that the illumination system 1110 is set in such a way that the projection light bundle passes the pupil plane 28 only in an annular region. This may be achieved, for example, by moving the axicon elements 27a, 27b apart, as is shown in FIG. 2. As a result, the polarization distributions across the pupils shown in FIG. 26 are restricted to annular regions as well. In the first mode of operation in which the rotator 1181 is retracted, the projection light is still completely linearly polarized with its initial polarization direction PDᵢ at location L2, i.e. immediately before the third polarization manipulator PM113. The third polarization manipulator PM113 now rotates the polarization direction depending on the location where a light ray passes the crystal 1101.

If the crystal 1101 is oriented within the illumination system 1110 such that the reference axis RA lies within the plane of the drawing sheet, this will result in the polarization distribution shown for location L3. This polarization distribution is characterized by a four-fold symmetry with alternating radial and tangential polarization directions. In the configuration shown, the tangential polarization directions are achieved at azimuth angles 0°, 90°, 180° and 270°, whereas a radial polarization direction is obtained at azimuth angles 45°, 135°, 225° and 315°. Since the crystal 1101 has a linear thickness profile, the polarization directions continuously alternate between tangential and radial polarization directions. If the crystal 1101 was designed with a step-like thickness profile, the polarization directions would not smoothly, but in a step-like fashion vary between tangential and radial polarization directions.

In the first mode of operation that is shown in FIG. 22, the half-wave plate 1198 is in an angular position such that its optic axis runs parallel to the initial polarization direction PDᵢ. This is schematically indicated in FIG. 26 by an axis orientation AO. With this orientation, the half-wave plate 1198 transforms.the polarization distribution at location L3 into the tangential polarization distribution that is desired on the mask M and shown for location L4. This may be easily understood if one bears in mind that a half-wave plate effectively mirrors a polarization direction at its optic axis.

FIG. 27 shows the illuminations system 1110 in a second mode of operation. In this second mode of operation, which is initiated by the control unit 1156, the rotator 1181 is inserted into the exchange holder 1171 by means of the actuator 1191. Apart from that, the half-wave plate 1198 has been rotated by an angle of 45° by the motor M11. The angular position of the third polarization manipulator PM113 is not changed.

FIG. 28 shows the polarization distributions in this second mode of operation in a representation similar to FIG. 26. Due to the insertion of rotator 1181, the polarization direction at location L2, i.e. immediately in front of the third polarization manipulator PM113, is now rotated by 90°. The third polarization manipulator P113 transforms this polarization distribution into the polarization distribution shown at location L3. This polarization distribution may be obtained from the polarization distribution at location L3 shown in FIG. 26 by rotating all polarization directions by 90°.

In FIG. 28 the rotated optic axis orientation AO' of the half-wave plate 1198 is schematically indicated. Due to this rotated axis orientation AO', the polarization distribution at location L3 is again transformed into a tangential polarization distribution in the vicinity of the mask M. The illumination system 1110 thus allows to obtain a tangential polarization distribution in both modes of operation, but with alternating polarization directions between the first and second polarization manipulators PM111 and PM112, respectively.

In contrast to the fifth embodiment shown in FIG. 13, the illumination system 1110 requires only one half-wave plate for the second polarization manipulator PM112. This half-wave plate 1198 may be configured as a zero-order plate. This is advantageous in view of the larger angles of incidence occurring at the location L4. For the same reason, the use of optically active crystals is difficult in this part of the illumination system because the geometrical path lengths will differ depending on the angle of incidence.

## Claims

1. An illumination system for a microlithographic projection exposure apparatus (PEA), comprising a first polarization manipulator (PM1; PM21; PM31; PM41; PM51; PM611, PM621; PM111), a second polarization manipulator (PM2; PM22; PM32; PM42; PM52; PM612, PM622; P112) and at least one optical element (L1, L2, 18, 30) located in between, wherein
a) the electric field vector of a light ray (R) entering the first polarization manipulator (PM1; PM21; PM31; PM41; PM51; PM611, PM621; P111) oscillates in a first direction (PDᵢ) that is fixed in time,
b) the electric field vector of a light ray (R) emitted from the first polarization manipulator (PM1; PM21; PM31; PM41; PM51; PM611, PM621; P111) oscillates in a second direction (PDₘ) that varies in time,
c) the electric field vector of a light ray (R) emitted from the second polarization manipulator (PM2; PM22; PM32; PM42; PM52; PM612, PM622; P112) oscillates in a third direction (PDₒ) that is fixed in time.

2. The illumination system of claim 1, wherein the
first polarization manipulator (PM1; PM611) produces elliptically polarized light.

3. The illumination system of claim 2, wherein the
first polarization manipulator (PM1; PM611) produces circularly polarized light.

4. The illumination system of claim 2, wherein the
first polarization manipulator (PM1; PM611) comprises a quarter-wave plate or a three-quarter-wave plate.

5. The illumination system of claim 3 and 4, wherein
the first polarization manipulator (PM1; PM611) comprises a quarter-wave plate or a three-quarter-wave plate having a principal axis that forms an angle of 45° to the first direction (PDᵢ).

6. The illumination system of one of claims 2 to 5,
wherein the second polarization manipulator (PM2; PM612) transforms elliptically polarized light into linearly polarized light.

7. The illumination system of claim 6, wherein the second polarization manipulator (PM2; PM612) comprises a quarter-wave plate or a three-quarter-wave plate.

8. The illumination system of claim 1, wherein the
first polarization manipulator (PM21; PM31; PM41; PM51; PM621) and the second polarization manipulator (PM22; PM32; PM42; PM52; PM622) each comprises a polarization rotator.

9. The illumination system of claim 8, wherein at
least one polarization rotator comprises a half-wave plate (PM31, PM32; PM51, PM52; PM621, PM622).

10. The illumination system of claim 8 or 9, wherein at
least one polarization rotator (PM621, PM622) comprises a first half-wave plate and a second half-wave plate that are arranged such that a principal axis of the first half-wave plate forms an angle of 45° with a principal axis of the second half-wave plate.

11. The illumination system of any of claims 8 to 10,
wherein at least one polarization rotator (PM21, PM22; PM41, PM42) comprises an optically active material.

12. The illumination system of claim 11, wherein the optically active material is a liquid crystal.

13. The illumination system of any of claims 8 to 12,
wherein at least one polarization rotator comprises a polarization modulator.

14. The illumination system of claim 13, wherein the polarization modulator exploits the magneto-optic effect or the electro-optic effect.

15. The illumination system of any of claims 8 to 14,
wherein the first polarization manipulator (PM41; PM51) and the second polarization manipulator (PM42; PM52) rotate the second direction intermittently.

16. The illumination system of claim 15 and of claims 10
to 12, wherein at least one polarization manipulator comprises an actuator (591, 952) for displacing the polarization rotator (581, 582) between a first position, in which the ray (R) passes through the polarization rotator (581, 582), and a second position, in which the ray (R) does not pass through the polarization rotator (581, 582).

17. The illumination system of claim 15 and of claims 13
or 14, wherein a control voltage given by a step function is applied to the polarization modulator (PM41, PM42).

18. The illumination system of any of claims 15 to 17,
wherein the first polarization manipulator (PM41, PM42) rotates the first direction by m·90°, m = 1, 3, 5, ... .

19. The illumination system of claim 18, wherein the
second polarization manipulator (PM42) reverses the rotation of the first direction that has been introduced by the first polarization manipulator (PM41).

20. The illumination system of claim 18 or 19, wherein a
third polarization manipulator (PM3) is arranged between the first (PM41, PM42; PM51, PM52) and the second polarization manipulator.

21. The illumination system of claim 20, wherein the
third polarization manipulator (PM3) transforms a linear homogeneous polarization distribution into a linear radial or linear tangential polarization distribution.

22. The illumination system of claim 21, wherein the
third polarization manipulator (PM3) is arranged in or in close proximity of a pupil plane (28) of the illumination system.

23. The illumination system of claim 1, comprising a
third polarization manipulator (PM113) arranged between the first polarization manipulator (PM111) and the second polarization manipulator (PM112), wherein said third polarization manipulator (PM113) comprises an optically active crystal (1101) having an optic axis that is parallel to an optical axis (OA) of the illumination system (1110), said crystal (1101) having a thickness along a direction of the optic axis that is locally varying.

24. The illumination system of claim 23, wherein the
thickness is constant in any radial direction pointing outward from an element axis (EA) of the third polarization manipulator (PM113).

25. The illumination system of claim 24, wherein the
thickness is exclusively a function of an azimuth angle (θ) that is related to a reference direction (RA) pointing radially outward from the element axis (EA).

26. The illumination system of claim 24 or 25, wherein
the element axis (EA) coincides with an optical axis (OA) of the illumination system (1110).

27. The illumination system of claim 1, comprising a
third polarization manipulator (PM113) arranged between the first polarization manipulator (PM111) and the second polarization manipulator (PM112) that produces a polarization distribution having a four-fold symmetry with polarization directions changing from radial to tangential orientations, and wherein the first polarization manipulator (PM111) is configured to rotate the first direction by m·90°, m = 1, 3, 5, ..., and wherein the second polarization manipulator (PM112) has the function of a half-wave plate (1198) having an optic axis whose direction can be varied by an angle of n·45°, n = 1, 3, 5, ....

28. The illumination system of claim 27, wherein the polarization directions continuously change from radially to tangentially.

29. The illumination system of claim 27 or 28, wherein
the third polarization manipulator (PM113) produces a polarization distribution with tangentially oriented polarization directions at azimuth angles of 0°, 90°, 180° and 270° and with radially oriented polarization directions at azimuth angles of 45, 135°, 225° and 315°, wherein the azimuth angle (θ) is related to a reference direction (RA) pointing radially outward from the element (EA) axis.

30. The illumination system of any of claims 27 to 29,
wherein the third polarization manipulator (PM113) is configured according to claim 25 or 26.

31. The illumination system of any of claims 27 to 30,
wherein the first polarization manipulator (PM111) comprises an actuator (1191) for displacing a polarization rotator (1181) between a first position, in which the ray passes through the polarization rotator (1181), and a second position, in which the ray does not pass through the polarization rotator (1181).

32. The illumination system of any of claims 27 to 31,
wherein the first polarization manipulator (PM111) comprises an optically active crystal.

33. The illumination system of any of claims 27 to 32,
wherein the second polarization manipulator (PM112) comprises a zero-order half-wave plate (1198).

34. The illumination system of claim 33, wherein the
second polarization manipulator (PM112) comprises an actuator (M11) for rotating the half-wave plate (1198).

35. The illumination system of any of claims 8 to 14,
wherein the first polarization manipulator (PM21; PM31) and the second polarization manipulator (PM22; PM32) rotate the second direction (PDₘ) continuously.

36. The illumination system of claim 35, wherein the
first polarization manipulator (PM21; PM31) and the second polarization manipulator (PM22; PM32) rotate the second direction (PDₘ) by a rotation angle α that is at least in the range between 0° and 90°.

37. The illumination system of any of the preceding
claims, wherein the second polarization manipulator (PM2; PM22; PM32; PM42; PM52; PM612, PM622; PM112) is the last optical element of the illumination system.

38. The illumination system of claim 1, comprising
a) a first pair of polarization manipulators (PM611, PM612),
b) a second pair of polarization manipulators (PM21, PM22) according to any of claims 2 to 25 and succeeding the first pair of polarization manipulators (PM611, PM612),
c) at least one further polarization manipulator (PM3) arranged between the first pair of polarization manipulators (PM611, PM612) and the second pair of polarization manipulators (PM621, PM622).

39. The illumination system of claim 1, wherein the
first pair of polarization manipulators (PM611, PM612) are configured according to any of claims 2 to 19.

40. The illumination system of claim 26, wherein the at
least one further polarization manipulator (PM3) transforms a linear homogeneous polarization distribution into a linear radial or linear tangential polarization distribution.

41. The illumination system of any of the preceding
claims, wherein the light ray (R) entering the first polarization manipulator (PM1; PM21; PM31; PM41; PM51; PM611, PM621) has the same polarization state as the light ray (R) emitted from the second polarization manipulator (PM2; PM22; PM32; PM42; PM52; PM612, PM622).

42. The illumination system of any of the preceding
claims, comprising a light source (14) for producing linearly polarized light.

43. The illumination system of any of the preceding
claims, wherein the first polarization manipulator PM1; PM21; PM31; PM41; PM51; PM611, PM621; PM111) is arranged between the light source (14) and a first optical raster element (18) that modifies the angular distribution of the light.

44. An illumination system for a microlithographic projection exposure apparatus (PEA), comprising:
a) an optical element (L1, L2) on which, during operation of the illumination system, a linearly polarized light ray having a fixed polarization direction (PDᵢ) is incident,
b) an actuator (740) for rotating the optical element (L1, L2) around an axis (OA) of rotation;
c) a control unit (748) that controls the actuator according to a predetermined control pattern.

45. The illumination system of claim 44, wherein the actuator (740) is adapted for rotating the optical element (L1, L2) by an angle of rotation of 90° or an uneven multiple thereof.

46. The illumination system of claim 44 or 45, wherein
the control unit (748) initiates the rotation during pauses between exposure operation intervals of the illumination system.

47. The illumination system of claim 44 or 45, wherein
the control unit (748) initiates the rotation during exposure operation of the illumination system.

48. The illumination system of any of claims 44 to 47, wherein the control unit (748) controls the actuator (740) such that it continuously rotates the optical element.

49. The illumination system of any of claims 44 to 47, wherein the control unit (748) controls the actuator (740) such that it intermittently rotates the optical element.

50. The illumination system of any of claims 44 to 49, wherein the control unit (748) controls the actuator (740) such that it rotates the optical element (L1, L2) by an angle of rotation of 90° or an uneven multiple thereof.

51. The illumination system of any of claims 44 to 50,
wherein the axis (OA) of rotation is an axis of symmetry of the optical element (L1, L2).

52. The illumination system of any of claims 44 to 51,
wherein the actuator (740) is connected to a plurality of optical elements (L1, L2).

53. A projection exposure apparatus comprising an
illumination system (10; 210; 310; 410; 510; 610; 1110) according to any of the preceding claims.

54. A projection exposure apparatus for exposing a layer
(PR) that is sensitive to light having a predetermined wavelength, comprising:
a) a first light source (14) emitting projection light rays having the predetermined wavelength,
b) an optical element (L81, L82) containing at least one point that is penetrated by projection light rays such that projection light at the at least one part has a dominant overall first polarization direction (830, 834),
c) a second light source (14; 914) emitting compensation light rays that can be directed to the optical element (L81, L82) such that compensation light at the at least one point has a dominant overall second polarization direction (832, 836) that forms an angle (α) with the dominant overall first polarization direction between 45,1° and 90°.

55. The projection exposure apparatus of claim 54,
wherein the compensation light has a wavelength for which the layer (PR) is not sensitive.

56. The projection exposure apparatus of claim 54, comprising a control unit connected to the second light source, wherein the control unit ensures that the second light source emits compensation light only during time intervals in which the light sensitive layer (PR) cannot be exposed by the compensation light rays.

57. The projection exposure apparatus of claim 54, comprising a shutter (816) that is connected to the control (813) unit and prevents an exposure of the light sensitive layer by the compensation light.

58. The projection exposure apparatus of claim 57,
wherein the shutter (816) is arranged immediately in front of the light sensitive layer (PR).

59. The projection exposure apparatus of any of claims 54 to 58, wherein the second light source is identical with the first light source (14).

60. The projection exposure apparatus of claim 59, comprising a polarization manipulator (812) that transforms the projection light into compensation light and can be inserted into a path of the projection light.

61. The projection exposure apparatus of claim 60,
wherein the polarization manipulator (812) rotates the polarization direction of light passing it by an angle of more than 45°.

62. The projection exposure apparatus of claim 60,
wherein the polarization manipulator (812) rotates the polarization direction of light passing it by an angle of 90° or an uneven multiple thereof.

63. The projection exposure apparatus of any of claims 54 to 62, wherein the compensation light rays are linearly polarized.

64. The projection exposure apparatus of any of claims 54 to 63, wherein the angle formed between the dominant overall first and second polarization directions is 90°.

65. The projection exposure apparatus of any of claims 54 to 64, wherein the compensation light rays penetrating the at least one point have polarization directions that are at least substantially orthogonal to the polarization directions of the projection light rays penetrating the at least one point.

66. A microlithographic method of fabricating a microstructured device, comprising the following steps:
a) providing a substrate (W) supporting a light sensitive layer;
b) providing a mask (M) containing structures (ST) to be imaged onto the light sensitive layer;
c) providing an illumination system (10; 210; 310; 410; 510; 610) according to any one of claims 1 to 53;
d) projecting at least a part of the mask (M) onto the light sensitive layer by means of a projection lens (PL).

67. A microstructured device, **characterized in that** it is fabricated according to the method of claim 66.

68. A method of operating a projection exposure apparatus used in the fabrication of micro-structured devices, comprising the following steps:
a) exposing a light sensitive layer (PR) with projection light rays that penetrate at least one part of an optical element (L81, L82) in such a way that projection light at the at least one part has a dominant overall first polarization direction (830, 834);
b) directing compensation light rays to the optical element such that compensation light at the at least one point has a dominant overall second polarization direction (832, 836) that forms an angle (α) with the dominant overall first polarization direction between 45,1° and 90°.

69. The method of claim 68, wherein the compensation light rays are linearly polarized.

70. The method of claim 69, wherein the compensation
light has a second polarization direction (832) that is at least substantially orthogonal to the first polarization direction (830).

71. The method of any of claims 68,to 70, wherein the
projection light rays and the compensation light rays are emitted by the same light source (14).

72. The method of claim 71, comprising the further steps of:
- inserting a polarization manipulator (812) into the path of the projection light that transforms the projection light into compensation light;
- preventing the compensation light from impinging on the light sensitive layer by a shutter (816).

73. A microlithographic method of fabricating a microstructured device, comprising the following steps:
a) providing a substrate (W) supporting a light sensitive layer (PR);
b) providing a mask (M) containing structures (ST) to be imaged onto the light sensitive layer;
c) providing an illumination system (710) comprising an optical element (L1, L2) on which, during operation of the illumination system, a linearly polarized light ray having a fixed polarization direction (PDᵢ) is incident;
d) rotating the optical element (L1, L2) according to a predetermined time pattern;
e) projecting at least a part of the mask (M) onto the light sensitive layer (PR) by means of a projection lens (PL).

74. A method of illuminating a mask (M) inserted in an object plane of a projection lens (PL) of a microlithographic projection exposure apparatus (PEA), comprising the following steps:
a) providing a light source (14) that produces linearly polarized light with a fixed polarization direction;
b) intermittently or continuously varying a direction, in which an electric field vector of a light ray (R) emitted by the light source (14) oscillates, before the light ray (R) passes through at least one optical element (L1, L2, 18, 30)
c) after the light ray (R) has passed through the at least one optical element (L1, L2, 18, 30), manipulating the direction of the electric field vector such that it is fixed in time.
